(19) Europäisches Patentamt / European Patent Office / Office européen des brevets

(11) **EP 4 366 160 B1**

(12) **EUROPEAN PATENT SPECIFICATION**

(45) Date of publication and mention
of the grant of the patent:
**19.11.2025 Bulletin 2025/47**

(21) Application number: **23813256.7**

(22) Date of filing: **08.05.2023**

(51) International Patent Classification (IPC):
***H02S 30/10*** *(2014.01)*

(52) Cooperative Patent Classification (CPC):
**H02S 30/00; F24S 25/632; F24S 25/636;
H02S 30/10;** Y02E 10/50

(86) International application number:
**PCT/CN2023/092661**

(87) International publication number:
**WO 2024/055606 (21.03.2024 Gazette 2024/12)**

(54) **PROFILE ASSEMBLY, PROFILE, PROFILE REINFORCEMENT MEMBER, PHOTOVOLTAIC MODULE FRAME, AND PHOTOVOLTAIC SYSTEM**

PROFILANORDNUNG, PROFIL, PROFILVERSTÄRKUNGSELEMENT, PHOTOVOLTAIKMODULRAHMEN UND PHOTOVOLTAIKANLAGE

ENSEMBLE PROFILÉ, PROFILÉ, ÉLÉMENT DE RENFORCEMENT DE PROFILÉ, CADRE DE MODULE PHOTOVOLTAÏQUE ET SYSTÈME PHOTOVOLTAÏQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **13.09.2022 CN 202222416211 U**

(43) Date of publication of application:
**08.05.2024 Bulletin 2024/19**

(73) Proprietor: **Trina Solar Co., Ltd
Changzhou, Jiangsu 213031 (CN)**

(72) Inventor: **XU, Jianmei
Changzhou, Jiangsu 213031 (CN)**

(74) Representative: **Nederlandsch Octrooibureau
P.O. Box 29720
2502 LS The Hague (NL)**

(56) References cited:
EP-B1- 2 318 780          CN-A- 113 904 620
CN-U- 202 633 356      CN-U- 212 543 719
CN-U- 216 252 633      CN-U- 217 240 648
CN-U- 217 335 520      CN-U- 218 514 329
DE-U1- 202011 003 534      US-A1- 2022 166 374

**Description**

Technical Field

The present application mainly relates to the installation frame of a photovoltaic module, especially to a profile component, a profile, a profile reinforcement, a photovoltaic module frame and a photovoltaic system.

Background

Profiles are objects with a certain geometric shape made from materials with certain strength and toughness through rolling, extruding, casting and other processes. Due to the limitations of the manufacturing process, the cross-sectional shape of a profile is generally fixed, and its shape and thickness are unified on each cross-section along the length direction. When selecting profiles, it is generally based on actual installation requirements to choose profiles that match the shape, material, mechanical properties, etc. In actual application scenarios, different positions of the profile bear different external forces, which results in deforming or even tearing in some parts of the profile. In order to avoid such deforming or tearing, in the existing technology, the overall profile is generally strengthened, such as overall thickening, which causes a waste of resources to a certain extent.

Profiles can be used to form various frames, which are installed on the periphery of the workpiece to support, fix and protect the corresponding workpiece.

As a specific application scenario, solar photovoltaic modules fix laminates including solar cells through the photovoltaic module frame. The function of the module frame is to enhance the mechanical strength of the module, seal the edges of the laminate, and fix the laminate on the bracket to form a solar photovoltaic module, referred to as a photovoltaic module or module. The photovoltaic module frame needs to be fixed on the purlins of the bracket through pressing parts. Usually, connection structures such as card slots are set on the frame of the photovoltaic module.

The main part of an existing photovoltaic module frame is generally made of aluminum alloy and is integrally formed by extrusion. Due to the aforementioned reasons, the same type of frame profiles have a uniform cross-sectional shape and thickness. The cross-sectional shape and thickness between the long and short sides of the module frame may be different, but are unified between the long and long sides and between the short and short sides are unified. In most cases, the cross-sectional shape and thickness between the long and short sides are also the same. The inventor of the present application realized that this would lead to the fact that when designing the module frame, the connection structure is extended entirely on the profile, and the strength of the frame needs to be designed according to the maximum stress point, so that the whole frame meets the strength requirement of the maximum stress point. This ultimately results in wasted material and cost.

EP 2 318 780 B1 describes a solar module frame having water drain. The disclosure relates to a frame for a solar module, wherein the frame comprises a plurality of aluminum extruded profiles, which form the sides of the frame and which are connected to each other at the corners thereof, wherein at least one aluminum extruded profile comprises at least one hollow chamber, wherein the frame comprises corner elements, wherein at least one corner element comprises a discharge opening, and the discharge opening is connected to a hollow chamber of at least one adjacent aluminum extruded profile.

Summary

The technical problem to be solved by the present application is to provide a profile component, according to claim 1, a profile, profile reinforcement, a photovoltaic module frame and a photovoltaic system that is low-cost and easy to install.

In order to solve the above technical problems, the present application provides a profile component, including a profile and a reinforcement, the profile includes an outer frame with a mold cavity inside and a load-bearing part located on the outer frame and used to carry workpieces to be installed, a first side wall and a first convex strip spaced opposite to an upper end of the first side wall, a first bayonet being formed between the first convex strip and the upper end of the first side wall, and the reinforcement has a connecting portion, an extending portion and a second convex strip protruding from an end of the extending portion, and when the reinforcement is combined with the outer frame through the connecting portion, a second bayonet is formed between the second convex strip, the extending portion and a lower end of the first side wall, the first convex strip is opposite to the second convex strip, and the first bayonet is opposite to the second bayonet, forming a side groove for installing a profile pressing piece.

In one embodiment of the present application, the lower end of the side wall does not exceed an inner edge of the convex strip in an outward direction perpendicular to the first side wall.

In one embodiment of the present application, the connecting portion includes an upwardly extending side plate adapted to be combined with a second side wall of the outer frame through a fastener, the second side wall being opposite to the first side wall.

In one embodiment of the present application, the outer frame has an opening in a bottom of the outer frame, and the connecting portion includes a sub-connecting portion inserted into the mold cavity through the opening.

In one embodiment of the present application, the connection portion includes a bottom plate adapted to be combined with a bottom surface of the outer frame through a fastener.

In one embodiment of the present application, the mold cavity includes a plurality of sub-cavities, and the sub-connecting portion is inserted into one of the sub-cavities.

In one embodiment of the present application, the mold cavity is a single mold cavity, and the sub-connecting portion is close to or against an inner top surface of the mold cavity.

In one embodiment of the present application, a top surface of the first bayonet and an end surface of the first convex strip are inclined upward in the direction from inside to outside, assuming that a thickness of the first convex strip is $b$, a height of the first convex strip is $e$, a width of the first bayonet is $c$, a distance between the end surface of the first convex strip and an end surface of the second convex strip is $H$, an inclination angle of the end surface of the first convex strip relative to a bottom surface of the profile is $\alpha$, and an inclination angle of a top surface of the first bayonet relative to the bottom surface of the profile is $\gamma$, then:

$$\alpha = argtan\left(\frac{b+c}{H+e}\right)$$

$$\gamma \geq \alpha.$$

In one embodiment of the present application, the inclination angles $\alpha$ and $\gamma$ are between 10-20°.

In one embodiment of the present application, an inclination angle of a top surface of the first bayonet and an end surface of the first convex strip relative to a bottom surface of the profile is 0°.

In one embodiment of the present application, an end surface of the second convex strip is inclined downward in a direction from inside to outside relative to a bottom surface of the reinforcement.

In one embodiment of the present application, an inclination angle of the end surface of the second convex strip relative to the bottom surface of the reinforcement is between 10-20°.

In one embodiment of the present application, the profile pressing piece has a coupling portion that is coupled to the side groove, the coupling portion including a first side and a second side and a third side that are respectively connected to both ends of the first side, the connection between the first side and the second side has a first protrusion, and the connection between the first side and the third side has a second protrusion, and when the profile is combined with the profile pressing piece, the first protrusion snaps into the first bayonet, and the second protrusion snaps into the second bayonet.

In one embodiment of the present application, a vertical distance between a bottom surface of the second bayonet and a bottom surface of the reinforcement is greater than or equal to a vertical distance between an end surface of the second protrusion and the bottom surface of the profile pressing piece.

In one embodiment of the present application, the second side of the profile pressing piece has a third protrusion spaced opposite to the first protrusion, and a first groove is formed between the first protrusion and the third protrusion to cooperate with the first convex strip, and a bottom surface of the first groove is inclined upward in a direction from outside to inside, and an inclination angle of the first groove relative to a bottom surface of the profile pressing piece is greater than or equal to an inclination angle of an end surface of the first convex strip relative to a bottom surface of the profile.

In one embodiment of the present application, an outer surface of the third protrusion is inclined inward in a direction from bottom to top, and an inclination angle of the outer surface relative to the first side is greater than or equal to an inclination angle of an end surface of the first convex strip relative to the bottom surface of the profile.

In one embodiment of the present application, a height of the first convex strip is 2.5-3.5mm, and/or a height of the second convex strip is 0.8-1.5mm.

In one embodiment of the present application, when the profile is combined with the profile pressing piece, a gap between the first side wall and a first side of the profile pressing piece is less than or equal to 2 mm.

In one embodiment of the present application, the first side wall has a lateral protrusion.

Another aspect of the present application also provides a profile according to claim 20, including an outer frame with a mold cavity inside and a load-bearing part located above the outer frame and used to load a workpiece to be installed, the outer frame further includes a side wall and a convex strip spaced opposite to an upper end of the side wall, a bayonet being formed between the convex strip and the upper end of the side wall, and a lower end of the side wall does not exceed an inner edge of the convex strip in an outward direction perpendicular to the side wall.

In one embodiment of the present application, the lower end of the side wall and the upper end of the side wall are flush with each other in an extending direction of the side wall.

In one embodiment of the present application, the outer frame has an opening in a bottom of the outer frame.

In one embodiment of the present application, an inclination angle $\alpha$ of an end surface of the convex strip relative to a bottom surface of the profile and an inclination angle $\gamma$ of a top surface of the bayonet relative to a bottom surface of the profile are between 10-20°.

In one embodiment of the present application, an inclination angle of a top surface of the bayonet and an end surface of the convex strip relative to a bottom surface of the profile is 0°.

In one embodiment of the present application, a height of the convex strips is 2.5-3.5mm.

Another aspect of the present application also provides a profile reinforcement according to claim 26, suitable for combination with a profile, the profile includes an outer frame having a cavity inside the outer frame, a first side wall and a first convex strip spaced opposite to an upper end of the first side wall, a first bayonet being formed between the first convex strip and an upper end of the first side wall, the profile reinforcement has a connecting portion, an extension portion and a second convex strip protruding from an end of the extension portion, and when the reinforcement is combined with the outer frame through the connecting portion, a second bayonet is formed between the second convex strip, the extending portion and a lower end of the first side wall, and the first convex strip is opposite to the second convex strip, and the first bayonet is opposite to the second bayonet, forming a side groove for installing a profile pressing piece.

In one embodiment of the present application, the connection portion includes an upwardly extending side plate adapted to be combined with a second side wall of the outer frame through a fastener, the second side wall being opposite to the first side wall.

In one embodiment of the present application, the outer frame has an opening in a bottom of the outer frame, and the connecting portion includes a sub-connecting portion inserted into the mold cavity through the opening.

In one embodiment of the present application, the connection portion includes a bottom plate adapted to be combined with the bottom surface of the outer frame through a fastener.

In one embodiment of the present application, an end surface of the second convex strip is inclined downward in a direction from inside to outside relative to a bottom surface of the reinforcement.

In one embodiment of the present application, an inclination angle of the end surface of the second convex strip relative to the bottom surface of the reinforcement is between 10-20°.

Another aspect of the present application also provides a photovoltaic module frame, including: a plurality of profile components according to any of embodiments above, and at least one profile pressing piece is installed on the side groove of the profile component.

In one embodiment of the present application, multiple profile components surround a closed area for carrying a photovoltaic component.

In one embodiment of the present application, at least some of the plurality of profile components are arranged adjacently, and the adjacently arranged profile components share the profile pressing piece.

Another aspect of the present application also provides a photovoltaic system including: a photovoltaic module frame according to any of embodiments above; and a plurality of photovoltaic cells arranged in the photovoltaic module frame.

Compared with the prior art, the profile component of the present application is assembled from the profile and the reinforcement. The reinforcement can not only strengthen local strength of the profile but also form a side groove together with the profile to facilitate installation of profile pressing piece. As a result, the structure of the profile is simplified, saving materials and costs. The installation process of the photovoltaic module frame and photovoltaic system in this application is simple and reduces labor costs.

Brief Description of the Drawings

The drawings are included to provide a further understanding of the present application, and they are included and constitute a part of the present application, the drawings show the embodiments of the present application, and serving to explain the principles of the present application together with the description. In the drawings:

FIG. 1A is a schematic side view of a profile for a photovoltaic module frame according to a first embodiment of the present application;
FIG. 1B is a schematic side view of a profile reinforcement for a photovoltaic module frame according to the first embodiment of the present application;
FIG. 1C is a schematic side view of a profile component for a photovoltaic module frame according to the first embodiment of the present application;
FIG. 2A and FIG. 2B are respectively a perspective view and a schematic side view of a pressing piece according to an embodiment of the present application;
FIG. 2C is a schematic side view of a pressing piece according to another embodiment of the present application;
FIG. 2D is a schematic side view of a pressing piece according to another embodiment of the present application;
FIG. 3 is a schematic diagram of the cooperation between a profile component and a pressing piece according to the first embodiment of the present application;
FIG. 4A is a schematic side view of a profile for a photovoltaic module frame according to a second embodiment of the present application;
FIG. 4B is a schematic side view of a profile reinforcement for a photovoltaic module frame according to the second embodiment of the present application;
FIG. 5 is a schematic diagram of the cooperation between a profile component and a pressing piece according to the second embodiment of the present application;
FIG. 6A is a schematic side view of a profile for a photovoltaic module frame according to a third embodiment of the present application;
FIG. 6B is a schematic side view of a profile reinforcement for a photovoltaic module frame according to the third embodiment of the present application;

FIG. 7 is a schematic diagram of the cooperation between the profile component and the pressing piece according to the third embodiment of the present application;

FIG. 8A is a schematic side view of a profile for a photovoltaic module frame according to a fourth embodiment of the present application;

FIG. 8B is a schematic side view of a profile reinforcement for a photovoltaic module frame according to the fourth embodiment of the present application;

FIG. 9 is a schematic diagram of the cooperation between the profile component and the pressing piece according to the fourth embodiment of the present application;

FIG. 10A is a schematic side view of a profile for a photovoltaic module frame according to a fifth embodiment of the present application;

FIG. 10B is a schematic side view of a profile reinforcement for a photovoltaic module frame according to the fifth embodiment of the present application;

FIG. 11 is a schematic diagram of the cooperation between the profile component and the pressing piece according to the fifth embodiment of the present application;

FIG. 12 is a schematic side view of a profile for a photovoltaic module frame according to a sixth embodiment of the present application;

FIG. 13 is a schematic diagram of the cooperation between the profile component and the pressing piece according to the sixth embodiment of the present application;

FIG. 14A- FIG. 14C are schematic diagrams of the assembly steps of a profile component and a profile pressing piece according to an embodiment of the present application;

FIG. 15 is a schematic assembly diagram of a profile component and a profile pressing piece according to an embodiment of the present application;

FIG. 16 is a schematic perspective view of photovoltaic module installation according to an embodiment of the present application.

Preferred Embodiment of the Present Invention

In order to illustrate the technical solutions in the embodiments of the present application more clearly, the drawings that need to be used in the description of the embodiments will be briefly introduced below. Obviously, the drawings in the following description are only some embodiments of the present application, and for those skilled in the art, other drawings can also be obtained based on these drawings without creative effort.

As indicated in this application and claims, the terms "a", "an", "a kind of" and/or "the" do not specifically refer to the singular and may include the plural unless the context clearly indicates an exception. Generally speaking, the terms "comprising" and "including" only suggest the inclusion of clearly identified steps and elements, and these steps and elements do not constitute an exclusive list, and the method or device may also contain other steps or elements.

The relative arrangements of components and steps, numerical expressions and numerical values set forth in these embodiments do not limit the scope of the present application unless specifically stated otherwise. At the same time, it should be understood that, for the convenience of description, the sizes of the various parts shown in the drawings are not drawn according to the actual proportional relationship. Techniques, methods and devices known to those of ordinary skill in the relevant art may not be discussed in detail, but where appropriate, such techniques, methods and devices should be considered part of the authorized specification. In all embodiments shown and discussed herein, any specific values should be construed as illustrative only, and not as limiting. Therefore, other examples of the exemplary embodiment may have different values. It should be noted that like numerals and letters denote like items in the following figures, therefore, once an item is defined in one figure, it does not require further discussion in subsequent drawings.

In the description of the present application, it should be understood that orientation words such as "front, back, up, down, left, right", " landscape, portrait, vertical, horizontal" and "top, bottom" etc. indicating the orientation or positional relationship is generally based on the orientation or positional relationship shown in the drawings, only for the convenience of describing the application and simplifying the description, in the absence of a contrary statement, these orientation words do not indicate or imply that the device or element referred to must have a specific orientation or be constructed and operated in a specific orientation, and therefore cannot be construed as limiting the scope of protection of this application; the orientation words "inside and outside" refer to inside and outside relative to the outline of each part itself.

For the convenience of description, spatially relative terms may be used here, such as "on ...", "over...", "on the upper surface of ...", "above", etc., to describe the spatial positional relationship between one device or feature and other devices or features. It will be understood that, in addition to the orientation depicted in the drawings, the spatially relative terms are intended to encompass different orientations of the device in use or operation. For example, if the device in the drawings is turned over, devices described as "on other devices or configurations " or "above other devices or configurations " would then be oriented "beneath other devices or configurations " or "under other devices or configurations ". Thus, the exemplary term "above" can encompass both an orientation of "above" and "beneath". The device may be otherwise oriented (rotated 90 degrees or at other orientations), and making a corresponding explanation for the space relative description used here.

In addition, it should be noted that the use of words such as "first" and "second" to define components is only for the convenience of distinguishing corresponding components, unless otherwise stated, the above words have no special meanings, and therefore cannot be construed as limiting the protection scope of the present application. In addition, although the terms used in this application are selected from well-known and commonly used terms, some terms mentioned in the specification of this application may be selected by the applicant according to his or her judgment, and their detailed meanings are listed in this article described in the relevant section of the description. Furthermore, it is required that this application be understood not only by the actual terms used, but also by the meaning implied by each term.

It will be understood that when an element is referred to as being "on," "connected to," or "in contacting with" another element, it can be directly on, connected to, or in contact with the other element, or there may be an intervening component. In contrast, when an element is referred to as being "directly on," "directly connected to," or "directly in contacting with" another element, there are no intervening elements present.

Embodiments of the present application describe a profile component, a profile and a profile reinforcement. The profile component includes a profile and a reinforcement, and the profile include an outer frame and a load-bearing part. The load-bearing part is located on the outer frame and is used to bear a workpiece to be installed. The outer frame has a mold cavity inside, and the outer frame has a first side wall and a first convex strip spaced opposite to an upper end of the first side wall. A first bayonet is formed between the first convex strip and the upper end of the first side wall. The reinforcement has a connecting portion, an extending portion and a second convex strip protruding from an end of the extending portion. When the reinforcement is combined with the outer frame through the connecting portion, a second bayonet is formed between the second convex strip, the extending portion and a lower end of the first side wall. The first convex strip is opposite to the second protruding strip, and the first bayonet is opposite to the second bayonet, thereby forming a side groove for installing a profile pressing piece.

Embodiments of the present application will be further described below with reference to the drawings.

First embodiment

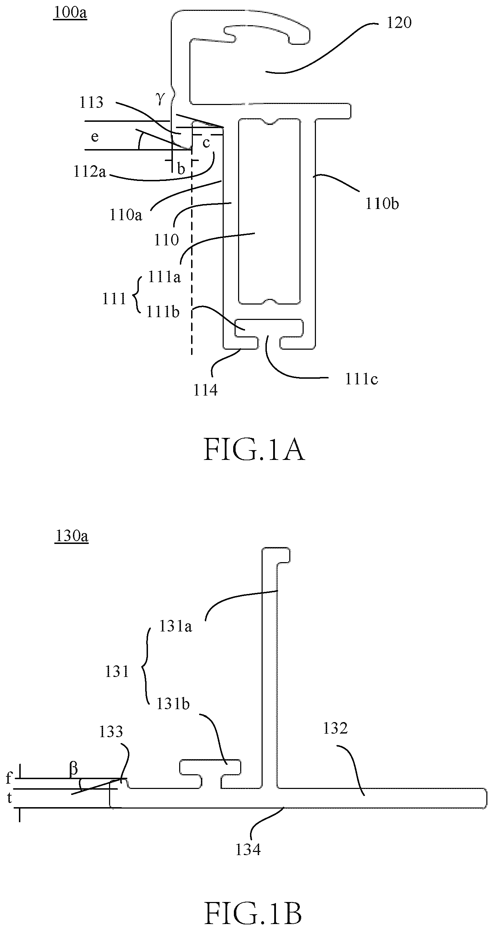

FIG. 1A is a schematic side view of a profile used for photovoltaic module frames according to a first embodiment of the present application. Referring to FIG. 1A, a profile 100a includes an outer frame 110 and a load-bearing part 120. The load-bearing part 120 is located on the outer frame 110 and is used to carry a workpiece to be installed, such as a photovoltaic cell. There is a mold cavity 111 inside the outer frame 110. In this embodiment, the mold cavity 111 includes two sub-cavities 111a and 111b. The outer frame has an opening 111c in its bottom, extending along the length direction of the profile 100a and communicating with the sub-cavity 111b. The outer frame 110 has a first side wall 110a and a second side wall 110b that are opposite to each other, and has a first convex strip 113 that is spaced opposite to an upper end of the first side wall. When the profile 100a is placed as shown in Fig. 1A, the first side wall 110a is a vertical surface, its lower end and upper end are flush with each other in the extending direction of the first side wall 110a, which saves material of the lower end of the side wall. The first convex strip 113 is substantially parallel to the first side wall 110a. A first bayonet 112a is formed between the first convex strip 113 and the upper end of the first side wall 110a.

It can be understood that in an embodiment not shown in the figure, for the purpose of improving strength, etc., the lower end of the side wall is allowed to protrude appropriately in the outward direction perpendicular to the first side wall (horizontally to the left in FIG. 1A). The size of the first side wall's protruding part should be small to save material. However, whether the lower end of the side wall is flush or protruding, it does not exceed an inner edge(i.e., the vertical dotted line in Fig. 1A) of the first convex strip 113 in the outward direction perpendicular to the first side wall, so as not to affect the combination with the reinforcement described later.

FIG. 1B is a schematic side view of a profile reinforcement for a photovoltaic module frame according to the first embodiment of the present application. Referring to FIG. 1B, the reinforcement 130a has a connecting portion 131, an extending portion 132, and a second convex strip 133 protruding from an end of the extending portion 132. The extending portion 132 extends substantially along the horizontal direction to form the bottom of the reinforcement 130a. In this embodiment, the connecting portion 131 includes a side plate 131a extending upward from the extending portion 132 and a sub-connection portion 131b. The side plate 131a may have a fastening hole for a fastener to pass.

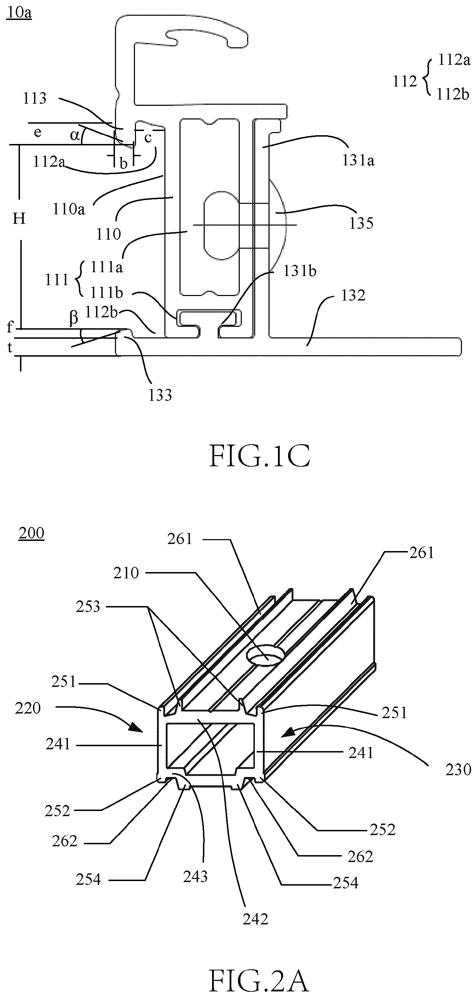

FIG. 1C is a schematic side view of a profile component used for a photovoltaic module frame according to the first embodiment of the present application. Referring to FIGS. 1A- 1C, the reinforcement 130a may be combined with the profile 100a to form a profile component 10a. Specifically, the reinforcement 130 is combined with the outer frame 110 of the profile 100a through the connecting portion 131. The side plate 131a is adapted to be combined with the second side wall 110b of the outer frame 110 through a fastener 135 such as a rivet. The sub-connecting portion 131b of the connecting portion 131 is inserted into the sub-cavity 111b through the opening 111c of the outer frame 110. At this time, a second bayonet 112b is formed between the second convex strip 133, the extending portion 132 and the lower end of the first side wall 110a. The first convex strip 113 and the second convex strip 133 are opposite to each other vertically, and the first bayonet 112a and the second bayonet 112b are opposite to each other, thereby forming a side groove 112 for installing a profile pressing piece.

In order to install the profile pressing piece that will be described later, the local angles and dimensions of the profile component 10 in this embodiment are designed as follows. On one hand, the top surface of the first bayonet 112a and the end surface of the first convex strip 113 are inclined upward in the direction from inside to outside (from right to left in the figure). Assume that the thickness of the first convex strip 113 is b, the height of the first convex strip is $e$, the width of the first bayonet 112a is c, the distance between the end surface of the first convex strip 113 and the end surface of the second convex strip 133 is H, the inclination angle of the end surface of the first convex strip 113 relative to the profile's bottom surface 114(which is basically horizontal) is $\alpha$, and the inclination angle of the top surface of the first bayonet 112a relative to the profile's bottom surface 114 is $\gamma$, then they satisfy the following set of formula (1):

$$\alpha = \mathrm{argtan}\left(\frac{b+c}{H+e}\right)$$

$$\gamma \geq \alpha \,。$$

In this embodiment, the inclination angles $\alpha$ and $\gamma$ are between 10-20°.

On the other hand, the end surface of the second convex strip 133 is inclined downward relative to the reinforcement's bottom surface 134 in the direction from inside to outside. In this embodiment, the inclination angle of the end surface of the second convex strip 133 relative to the reinforcement's bottom surface 134 is between 10-20°.

In terms of sizes, the height of the first convex strip is 2.5-3.5mm, and the height of the second convex strip is 0.8-1.5mm. These angles and dimensions will be discussed later.

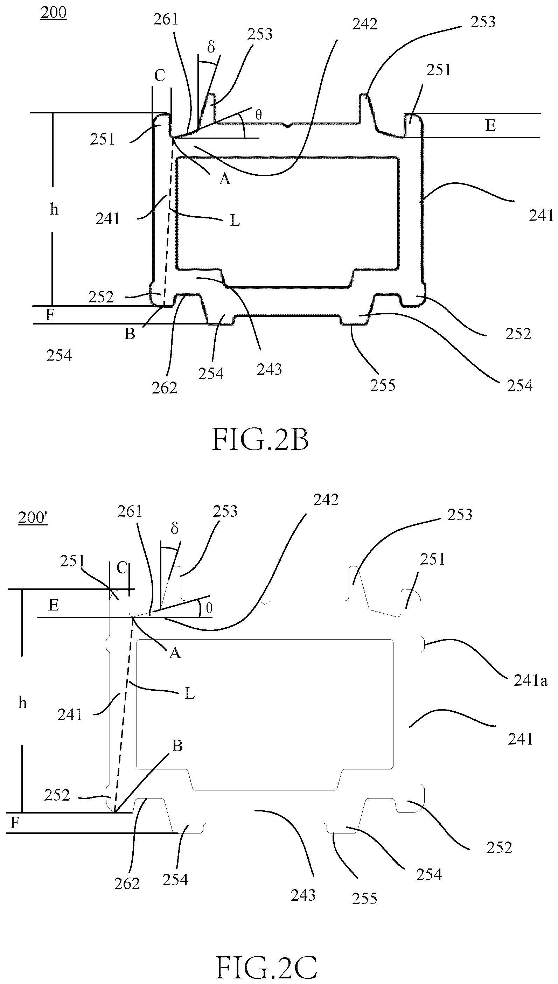

FIG. 2A and FIG. 2B are respectively a perspective view and a schematic side view of a pressing piece according to an embodiment of the present application. Referring to FIG. 2A and 2B, an embodiment of the present application provides a profile pressing piece 200 for combining and fixing the profile 100a. The profile pressing piece 200 has a first coupling portion 220 on one side for coupling with the side groove 112 of the profile 100a, the other side opposite to the one side of the profile pressing piece 200 has a second coupling portion 230 for coupling with a side groove 112 of another profile 100a of the same shape, and the profile pressing piece 200 has a fastening hole 210 passing through it. Specifically, in this embodiment, the fastening hole 210 is located in the middle of the profile pressing piece 200.

Further, the first coupling portion 220 and the second coupling portion 230 respectively include a first side 241, and include a second side 242 and a third side 243 respectively connecting two ends of the first side 241. Here, the second sides of the first coupling portion 220 and the second coupling portion 230 extends as one body, so do the third sides of the first coupling portion 220 and the second coupling portion 230. The connection between the first side 241 and the second side 242 has a first protrusion 251, and the connection between the first side 241 and the third side 243 has a second protrusion 252. In this embodiment, the profile pressing piece 200 is axially symmetrical. The first coupling portion 220 is the left part of the profile pressing piece 200, and the second coupling portion 230 is the right part of the profile pressing piece 200. In the figure, the left side of the profile pressing piece 200 is the first side 241 of the first coupling portion 220; the right side of the profile pressing piece 200 is the first side 241 of the second coupling portion 230; the left and right sides of the upper side of the profile pressing piece 200 are respectively the second sides 242 of the first coupling portion 220 and the second coupling portion 230; the left and right sides of the lower side of the profile pressing piece 200 are respectively the third sides 243 of the first coupling portion 220 and the second coupling portion 230. In addition, the profile pressing piece 200 has first protrusions 251 in the upper left corner and an upper right corner respectively, and second protrusions 252 in the lower left corner and lower right corner respectively.

FIG. 2C is a schematic side view of a pressing piece according to another embodiment of the present application. In FIG. 2C, the same reference numerals as in the previous embodiment represent the same components. Referring to FIG. 2C, in this embodiment, the profile pressing piece 200' has lateral protrusions 241a on both sides.

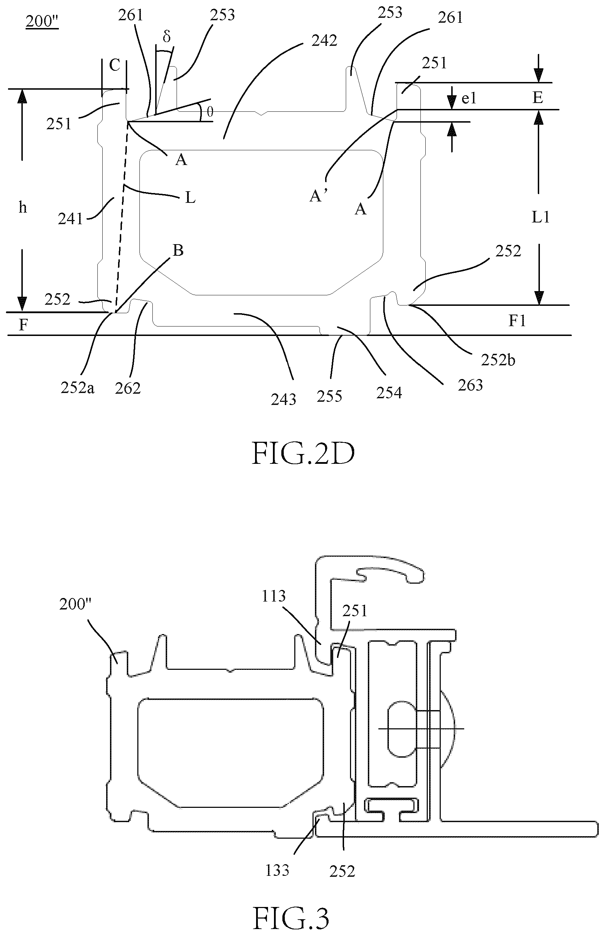

FIG. 2D is a schematic side view of a pressing piece according to another embodiment of the present application. In FIG. 2D, the same reference numerals as in the previous embodiment represent the same components. Referring to FIG. 2D, compared with the previous embodiment, the profile pressing piece 200'' in this embodiment has a similar structure of the first coupling portion 220, the difference is that the height of the end surface 252b of the second protrusion 252 of the second coupling portion 230 relative to the profile pressing piece's bottom surface 255 is higher than that of the end surface 252a of the second protrusion 252 of the first coupling portion 220 relative to the profile pressing piece's bottom surface 255.

Since the first coupling portion 220 of the profile pressing piece 200" in FIG. 2D is similar to that of FIG. 2B and FIG. 2C, FIG. 2D is now used as an example of the profile pressing piece for description. Referring to FIG. 1C, FIG. 2D and FIG. 3, when the profile pressing piece 200" is combined with the profile component 10a, the first protrusion 251 crosses the first convex strip 113 and snaps into the first bayonet 112a of the side groove 112, and the second protrusion 252 crosses the second convex strip 133 and snaps into the second bayonet 112b of the side groove 112. Since the height of the end surface 252b of the second protrusion 252 of the second coupling portion 230 relative to the profile pressing piece's bottom surface 255 is higher than the height of the end surface 252a of the second protrusion 252 of the first coupling portion 220 relative to the profile pressing piece's bottom surface 255, this makes it easier for the second coupling portion 230 to be coupled with the side groove of the profile component 10a while still maintaining the fixation after coupling.

In addition, an elastic strip (not shown in the figures) may be provided in the third groove 263 of the second coupling portion 230. When the second coupling portion of the profile pressing piece 200" is coupled to the profile component 10a, the elastic strip of the second coupling portion 230 contacts the second convex strip 133. In the embodiment of the present application, the elastic strip is a rubber strip or a spring clip.

In the embodiment of the present application, through the special design of the profile component 10a and the profile pressing piece 200, 200' or 200" as described above, the profile pressing piece can be inserted into the side groove 112 of the profile component 10a from the side, when tilted at a smaller angle, for example 10-20°, relative to the bottom surface of the profile component, which is the reinforcement's bottom surface 134. When $\alpha$ and $\gamma$ meet the aforementioned conditions, the profile pressing piece can rotate into the side groove of the profile, when tilted at a smaller angle relative to the profile's bottom surface 117.

In addition, the end surface of the second convex strip 133 is inclined downward in the direction from inside to outside, and its inclination angle relative to the reinforcement's bottom surface 134 is $\beta$. In some embodiments, the angle range of $\alpha$, $\beta$ and $\gamma$ is 10-20°, optionally 15-18°.

In addition, the height of the first convex strip 113 should not be too high, so that the profile pressing piece 200" can rotate into the side groove of the profile when tilted at a smaller angle relative to the profile. Moreover, the height of the first convex strip 113 should not be too low, otherwise the profile pressing piece 200" will easily detach from the side groove. For example, the height e of the first convex strip 113 is 2.5-3.5 mm. The height of the second convex strip 133 should not be too high, so that the profile pressing piece 200 can rotate into the side groove of the profile. Moreover, the height of the second convex strip 133 should not be too low, otherwise the profile pressing piece 200 will easily detach from the side groove. For example, the height $f$ of the second convex strip 133 is 0.8-1.5 mm. Correspondingly, in the profile pressing piece 200, the distance $h$ between the end surface of the first protrusion 251 and the end surface of the second protrusion 252 is larger than the distance $H$ between the end surface of the first convex strip 113 of the side groove 112 and the lower wall surface of the side groove, and $h$ is smaller than $H+e$, usually only slightly smaller. The second side 242 of the profile pressing piece 200" is inclined upward in the direction from outside to inside, and its inclination angle relative to the profile pressing piece's bottom surface 255 (when the profile pressing piece 200" is laid flat, the profile's bottom surface 255 is horizontal) is $\theta$. The third protrusion 253 has an inclined surface facing the first protrusion 251, and the inclination angle of the inclined surface relative to the first side 241 (when the profile pressing piece 200" is laid flat, the first side 241 is vertical) is $\delta$. Here, $\theta \geq \alpha$, and $\delta \geq \alpha$, so that when the profile pressing piece 200" is rotated into the side groove, it will not be hindered by the top surface of the side groove or the first convex strip.

It can be understood that when the profile component and the profile pressing piece are matched, the space to accommodate a certain part should be slightly larger than that part. For example, the depth c of the side groove 112 (the width of the first bayonet 112a and the second bayonet 112b) is slightly larger than the thickness C of the first protrusion 251 (left and right direction in the figure), the thickness of the projection of the first groove 261 in the horizontal direction is slightly larger than the thickness of the first convex strip 113, the depth c of the side groove 112 is also slightly larger than the thickness of the second protrusion 252 (in the left and right direction in the figure), the thickness of the projection of the second groove 262 in the horizontal direction is larger than the thickness of the second convex strip 114, and the height $E$ of the first protrusion 251 is slightly larger than the height $e$ of the first convex strip 113, and so on.

In addition, the vertical distance between the end surface (or bottom surface) of the second protrusion 252 on the left and the bottom surface of the profile pressing piece is $F$, then $F$ is less than or equal to the vertical distance $t$ between the bottom surface of the second bayonet 112b and the bottom surface of the reinforcement 134. In this way, after the profile and the profile pressing piece are assembled, the second protrusion 252 can be pressed against the bottom surface of the side groove 113. The distance $L$ between the outer end point $A$ of the first groove 261 on the left and the lower end $B$ of the second protrusion 252 is less than or equal to the width $H$ of the side groove's notch, so that the profile pressing piece 200 can be snapped into the side groove. Since the profile pressing piece 200 and 200' in FIG. 2B and FIG. 2C have a symmetrical structure, the second protrusions 252 and the first grooves 261 on both sides meet this condition and cooperate with profiles with the same structure and parameters.

Through the above design, the profile pressing piece can be slightly tilted, and the first protrusion 251 crosses the first convex strip 113 and is inserted into the side groove 112, meanwhile the second side 242 cooperates with the end surface of the first convex strip 113, and the profile pressing piece rotates in a direction such that the bottom surface 255 of the profile pressing piece is parallel to the bottom surface 134 of the profile component, and the second protrusion 252 crosses the second convex strip 133 and enters the side groove 112. Since the aforementioned *h* is larger than *H,* the profile pressing piece 200 cannot easily slide out of the side groove 112.

When the profile pressing piece is combined with the profile component 10a, the gap between the side surface of the profile pressing piece (more specifically, the second side 242) and the side surface of the side groove 112 of the profile component 10a is less than or equal to 2mm. In one embodiment, lateral protrusions can be provided on the sides of the side groove 112, which can limit the gap between the sides of the side groove 112 and the second side 242 of the profile pressing piece 200a.

It should be emphasized that the above-mentioned "left and right sides" are merely directional concepts for ease of understanding, and do not mean that the upper side/lower side of the profile pressing piece 200 are actually two separate parts.

Further, in this embodiment, the second side 242 has a third protrusion 253 spaced apart from the first protrusion 251, and the third side 243 has a fourth protrusion 254 spaced apart from the second protrusion 252. A first groove 261 is formed between a protrusion 251 and the third protrusion 253 to cooperate with the first convex strip 113, and a second groove 262 is formed between the second protrusion 252 and the fourth protrusion 254 to cooperate with the second convex strip 133, for example, snap-fitted. Similarly, in this embodiment, the left and right sides of the upper side of the profile pressing piece are respectively provided with a third protrusion 253; the left and right sides of the lower side of the profile pressing piece are respectively provided with a fourth protrusion 254. Furthermore, in this embodiment, there are two symmetrical first grooves 261 and two second grooves 262 on the profile pressing piece. It is worth noting that when the fourth protrusion 254 is present, the bottom surface 255 of the profile pressing piece is the end surface of the fourth protrusion 254. When there is no fourth protrusion 254, the bottom surface of the profile pressing piece is the surface between the two fourth protrusions 254 in FIG. 2B.

In the example of FIG. 2D, the size of the second coupling portion 230 is different from that of the first coupling portion 220. In particular, the vertical distance L1 between the floating external endpoint A' of the first groove 261 of the second coupling portion 230 and the end surface 252b of the second protrusion 252 of the second coupling portion 230 is less than or equal to the width *H* of the side groove's notch. Here, when the profile pressing piece 200'' is combined with the profile component 10a, the floating external endpoint A' is the lowest point where the first groove 261 contacts the lower end point of the first convex strip of the profile component 10a, and the floating external endpoint A' is higher than the external endpoint A. For example, the height difference e1 between the floating external endpoint A' and the external endpoint A is equal to the height f of the second convex strip 133. Moreover, the vertical distance *F1* from the second protrusion's end surface 252b of the second coupling portion 230 to the bottom surface of the profile pressing piece 200b is greater than or equal to the vertical distance (*f+t*) between the second convex strip 133 of the side groove and the reinforcement's bottom surface 134 (referring to Figure 1C). Through these designs, the profile pressing piece 200'' can be snapped into the side groove of the profile.

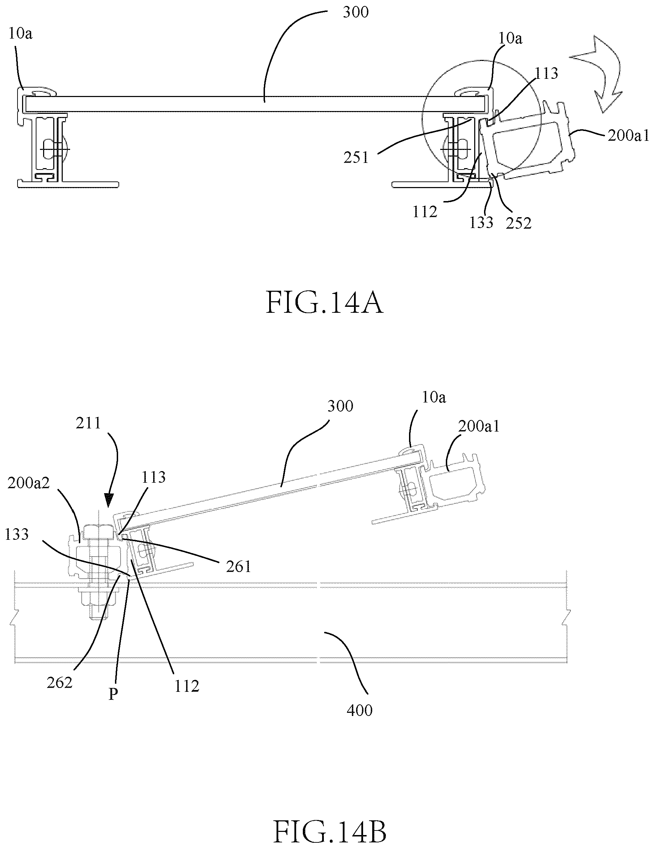

It is worth mentioning that the relationship between *L1* and *H* is designed so that after the profile pressing piece 200'' is installed in place by a fastener, another profile component can still be combined with the profile pressing piece 200'' (this will be described later with reference to FIGS. 14A-14C). In some embodiments, a chamfer can be designed at the position *P* where the lower left corner of the profile component 10a (referring to FIG. 14B) contacts a bracket, to reduce the height of the passive elevation of the profile 100a when installed, thereby reducing the height of the floating external endpoint A'. Of course, if the fastener 211 is not tightened during installation, so that the profile pressing piece 200' has an amount of up and down movement of the second convex strip's height *f*, then the second coupling portion 230 only needs to satisfy the relationship between *L* and *H.*

Second embodiment

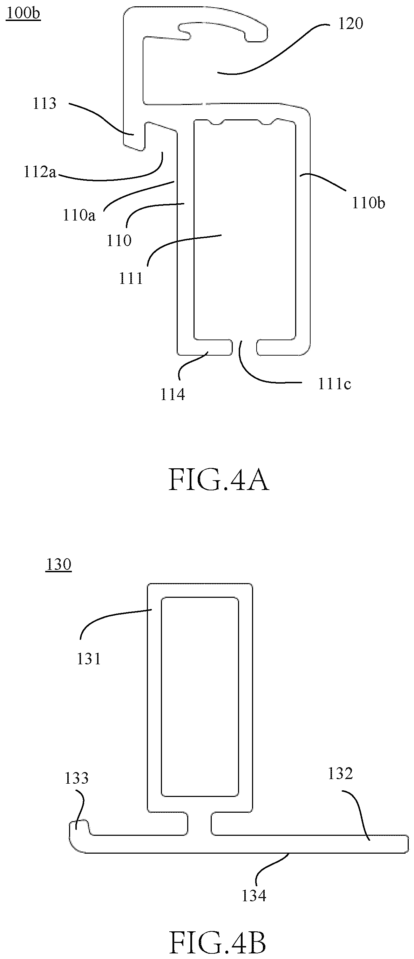

FIG. 4A is a schematic side view of a profile used for photovoltaic module frames according to the second embodiment of the present application. In this embodiment, the same or substantially the same structures as those in the previous embodiment are given the same reference numerals. Referring to FIG. 4A, a profile 100b includes an outer frame 110 and a load-bearing part 120. The load-bearing part 120 is located on the outer frame 110 and is used to carry a workpiece to be installed, such as a photovoltaic cell. There is a mold cavity 111 inside the outer frame 110. Different from the first embodiment, the mold cavity 111 is a single mold cavity. The outer frame has an opening 111c in its bottom, extending along the length direction of the profile 100b and communicating with the mold cavity 111. The outer frame 110 has a first side wall 110a and a second side wall 110b that are opposite to each other, and has a first convex strip 113 that is spaced opposite to an upper end of the first side wall. When the profile 100b is placed as shown in FIG. 4A, the first side wall 110a is a vertical surface, and the lower end and upper end of the side wall are flush with each other in the extending direction of the first side wall 110a, or protrude outward appropriately as mentioned in the first embodiment. The first convex strip 113 is substantially parallel to the first side wall 110a. A first bayonet 112a is formed between the first convex 113 and the upper end of the first side wall 110a.

FIG. 4B is a schematic side view of a profile reinforcement for a photovoltaic module frame according to the second embodiment of the present application. Referring to FIG. 4B, the reinforcement 130b has a connecting portion 131, an extending portion 132 , and a second convex strip 133 protruding from an end of the extending portion 132. The extension portion 132 extends substantially along the horizontal direction to form the bottom of the reinforcement 130b. In this example, the connecting portion 131 has a rectangular cross-section.

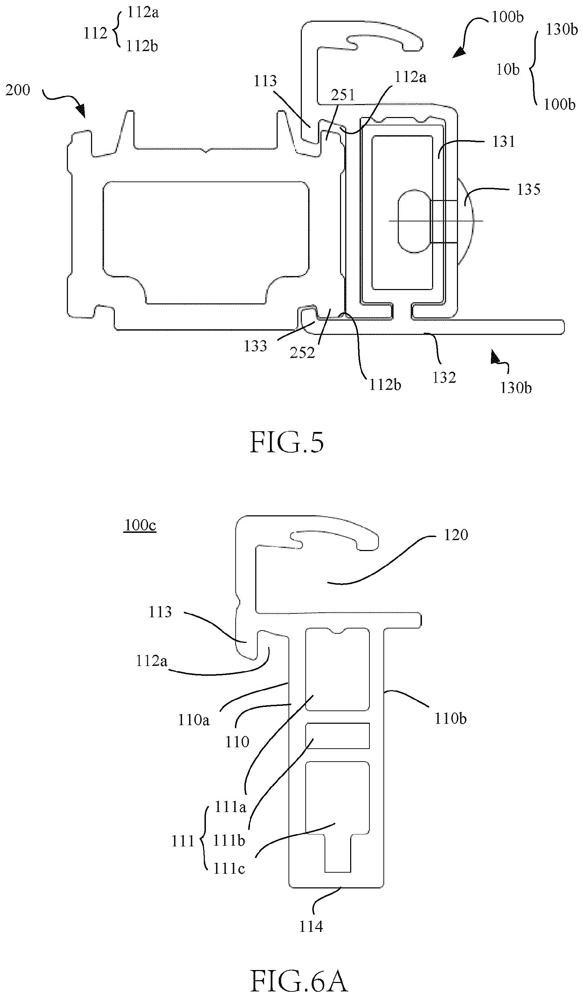

FIG. 5 is a schematic diagram of the cooperation between the profile component and the pressing piece according to the second embodiment of the present application. Referring to FIGS. 4A-5, the reinforcement 130b is combined with the profile 100b to form a profile component 10b. Specifically, the connecting portion 131 of the reinforcement 130b is inserted into the mold cavity 111 through the opening 111c of the outer frame 110, and is close to or against the inner top surface of the mold cavity 111. At this time, a second bayonet 112b is formed between the second convex strip 133, the extending portion 132 and the lower end of the first side wall 110a. The first convex strip 113 and the second convex strip 133 face each other vertically, and the first bayonet 112a and the second bayonet 112b face each other, thereby forming a side groove 112 for installing a profile pressing piece. The structure of the profile pressing piece 200 is the same as that of the first embodiment. Referring to FIG. 5, when the profile pressing piece 200 is combined with the profile component 10b, the first protrusion 251 crosses the first convex strip 113 and snaps into the first bayonet 112a of the side groove 112, and the second protrusion 252 crosses the second convex strip 133 and snaps into the second bayonet 112b of the side groove 112.

In order to facilitate the installation of the profile pressing piece 200, the local angle and size design of the profile component 10b in this embodiment can be referred to the design in the first embodiment, and will not be elaborated here.

Third embodiment

FIG. 6A is a schematic side view of a profile used for photovoltaic module frames according to the third embodiment of the present application. In this embodiment, the same or substantially the same structures as those in the previous embodiment are given the same reference numerals. Referring to FIG. 6A, the profile 100c includes an outer frame 110 and a load-bearing part 120. The load-bearing part 120 is located on the outer frame 110 and is used to carry a workpiece to be installed, such as a photovoltaic cell. There is a mold cavity 111 inside the outer frame 110. Different from the first embodiment, the mold cavity 111 includes three sub-cavities 111a, 111b and 111c. The outer frame 110 has a first side wall 110a and a second side wall 110b that are opposite to each other, and has a first convex strip 113 that is spaced opposite to the upper end of the first side wall. The sub-cavity 111b has a screw hole (not shown in the figure) facing the second side wall 110b, and the sub-cavity 111c has a screw hole (not shown in the figure) facing the profile's bottom surface 114. When the profile 100c is placed as shown in FIG.6A, the first side wall 110a is a vertical surface, and the lower end and upper end of the side wall are flush with each other in the extension direction of the first side wall 110a, or protrude outward appropriately as mentioned in the first embodiment. The first convex strip 113 is substantially parallel to the first side wall 110a. A first bayonet 112a is formed between the first convex strip 113 and the upper end of the first side wall 110a.

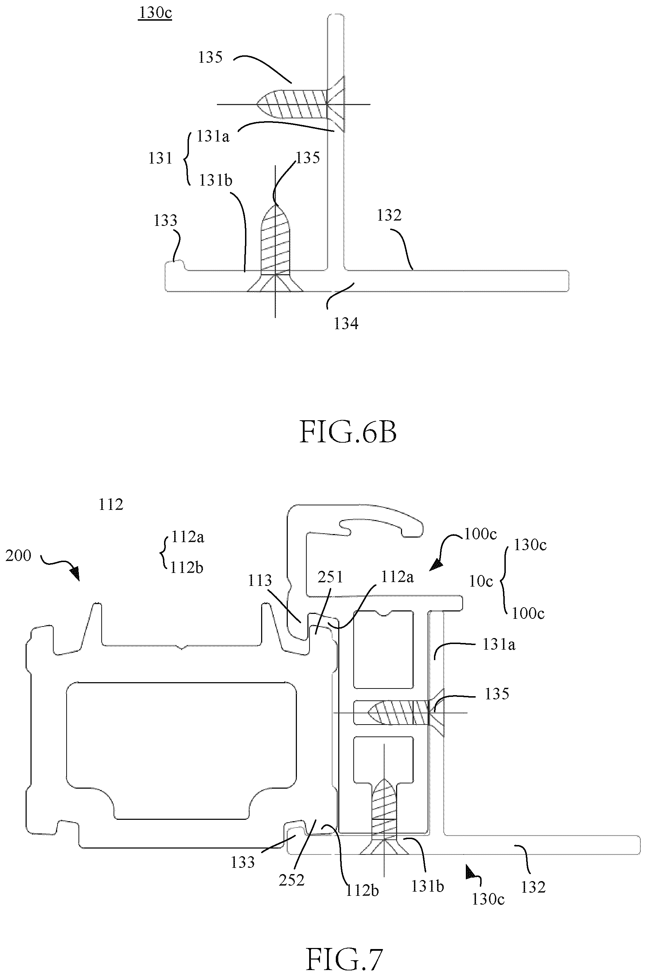

FIG. 6B is a schematic side view of a profile reinforcement for a photovoltaic module frame according to the third embodiment of the present application. Referring to FIG. 6B, the reinforcement 130c has a connecting portion 131, an extending portion 132, and a second convex strip 133 protruding from the end of the extending portion 132. The extension portion 132 extends substantially along the horizontal direction to form the bottom of the reinforcement 130c. In this example, the connecting portion 131 includes a side plate 131a extending upward from the extending part 132 and a bottom plate 131b extending integrally with the extending portion 132. Screw holes are respectively provided on the side plate 131a and the bottom plate 131b, and fasteners 135 such as screws can be passed through respectively.

FIG. 7 is a schematic diagram of the cooperation between the profile component and the pressing piece according to the third embodiment of the present application. Referring to FIGS. 6A-7, the reinforcement 130c is combined with the profile 100c to form a profile component 10c. Specifically, the side plate 131a and the bottom plate 131b of the reinforcement 130c are respectively combined with the second side wall 110b and the bottom surface 114 of the outer frame 110 through fasteners 135. At this time, a second bayonet 112b is formed between the second convex strip 133, the extending portion 132 and the lower end of the first side wall 110a. The first convex strip 113 and the second convex strip 133 face each other vertically, and the first bayonet 112a and the second bayonet 112b face each other, thereby forming a side groove 112 for installing the profile pressing piece. The structure of the profile pressing piece 200 is the same as that of the first embodiment. Referring to FIG. 7, when the profile pressing piece 200 is combined with the profile component 10c, the first protrusion 251 crosses the first convex strip 113 and snaps into the first bayonet 112a of the side groove 112, and the second protrusion 252 crosses the second convex strip 133 and snaps into the second bayonet 112b of the side groove 112.

In order to facilitate the installation of the profile pressing piece 200, the local angle and size design of the profile component 10c in this embodiment can be referred to the design in the first embodiment, which will not be elaborated here.

Fourth embodiment

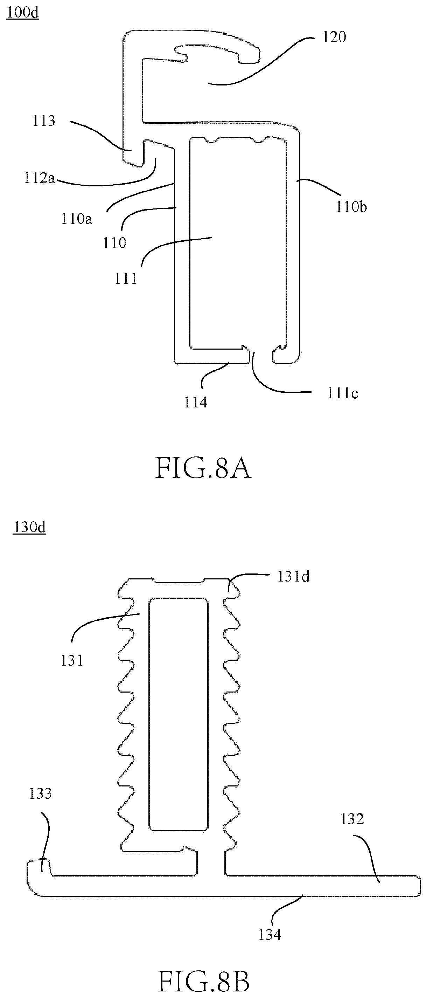

FIG. 8A is a schematic side view of a profile used for a photovoltaic module frame according to the fourth embodiment of the present application. In this embodiment, the same or substantially the same structures as those in the second embodiment are given the same reference numerals. Referring to FIG. 8A, a profile 100d includes an outer frame 110 and a load-bearing part 120. The load-bearing part 120 is located on the outer frame 110 and is used to carry a workpiece to be installed, such as a photovoltaic cell. Similar to the second embodiment, the outer frame 110 has a mold cavity 111 inside. The outer frame has an opening 111c in its bottom, extending along the length direction of the profile 100b and communicating with the mold cavity 111. The outer frame 110 has a first side wall 110a and a second side wall 110b that are opposite to each other, and has a first convex strip 113 that is spaced opposite to an upper end of the first side wall. When the profile 100b is placed as shown in FIG. 8A, the first side wall 110a is a vertical surface, and the lower end and upper end of the side wall are flush with each other in the extending direction of the first side wall 110a, or protrude outward appropriately as mentioned in the first embodiment. The first convex strip 113 is substantially parallel to the first side wall 110a. A first bayonet 112a is formed between the first convex strip 113 and the upper end of the first side wall 110a.

FIG. 8B is a schematic side view of a profile reinforcement for a photovoltaic module frame according to the fourth embodiment of the present application. Referring to FIG. 8B, the reinforcement 130d has a connecting portion 131, an extending portion 132 , and a second convex strip 133 protruding from an end of the extending portion 132. The extension portion 132 extends substantially along the horizontal direction to form the bottom of the reinforcement 130b. In this example, the connecting portion 131 has a substantially rectangular cross-section, and the outer edge of the connecting portion 131 has serrations 131d to improve the bonding strength with the profile 100d.

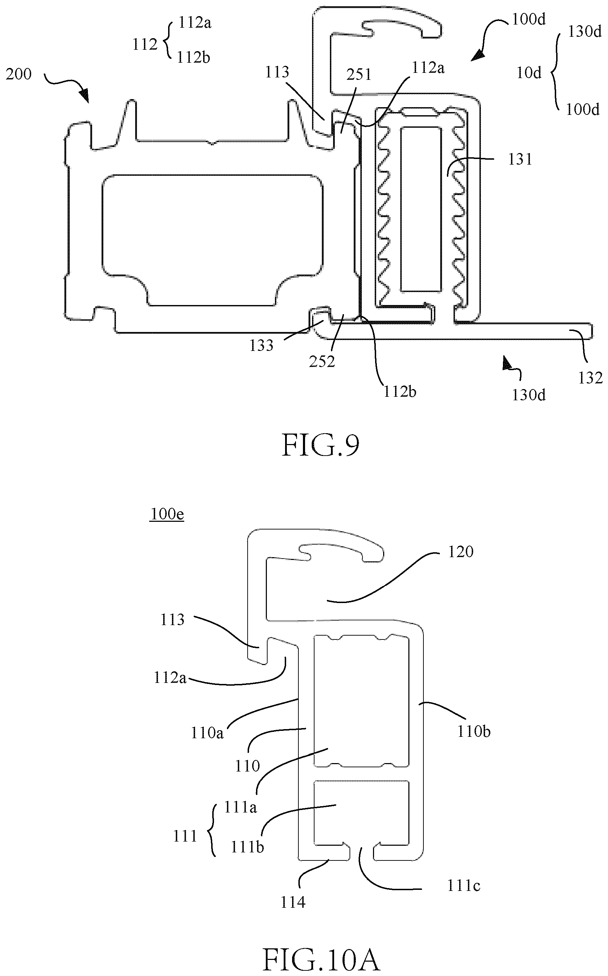

FIG. 9 is a schematic diagram of the cooperation between the profile component and the pressing piece according to the fourth embodiment of the present application. Referring to FIGS. 8A-9, the reinforcement 130d is combined with the profile 100d to form a profile component 10d. Specifically, the connecting portion 131 of the reinforcement 130d is inserted into the mold cavity 111 through the opening 111c of the outer frame 110, and is close to or against the inner top surface of the mold cavity 111. At this time, a second bayonet 112b is formed between the second convex strip 133, the extending portion 132 and the lower end of the first side wall 110a. The first convex strip 113 and the second convex strip 133 face each other vertically, and the first bayonet 112a and the second bayonet 112b face each other, thereby forming a side groove 112 for installing the profile pressing piece. The structure of the profile pressing piece 200 is the same as that of the first embodiment. Referring to FIG. 9, when the profile pressing piece 200 is combined with the profile component 10d, the first protrusion 251 crosses the first convex strip 113 and snaps into the first bayonet 112a of the side groove 112, and the second protrusion 252 crosses the second convex strip 133 and snaps into the second bayonet 112b of the side groove 112.

In order to facilitate the installation of the profile pressing piece 200, the partial angle and size design of the profile component 10d in this embodiment can be referred to the design in the first embodiment, and will not be elaborated here.

Fifth embodiment

FIG. 10A is a schematic side view of a profile used for a photovoltaic module frame according to the fifth embodiment of the present application. In this embodiment, the same or substantially the same structures as those of the fourth embodiment are given the same reference numerals. Referring to FIG. 10A, a profile 100e includes an outer frame 110 and a load-bearing part 120. The load-bearing part 120 is located on the outer frame 110 and is used to carry a workpiece to be installed, such as a photovoltaic cell. There is a mold cavity 111 inside the outer frame 110, and the mold cavity 111 includes two sub-cavities 111a and 111b. The outer frame has an opening 111c in its bottom, extending along the length direction of the profile 100a and communicating with the sub-cavity 111b. The outer frame 110 has a first side wall 110a and a second side wall 110b that are opposite to each other, and has a first convex strip 113 that is spaced opposite to an upper end of the first side wall. When the profile 100b is placed as shown in FIG. 10A, the first side wall 110a is a vertical surface, and the lower end and upper end of the side wall are flush with each other in the extending direction of the first side wall 110a, or protrude outward appropriately as mentioned in the first embodiment. The first convex strip 113 is substantially parallel to the first side wall 110a. A first bayonet 112a is formed between the first convex strip 113 and the upper end of the first side wall 110a.

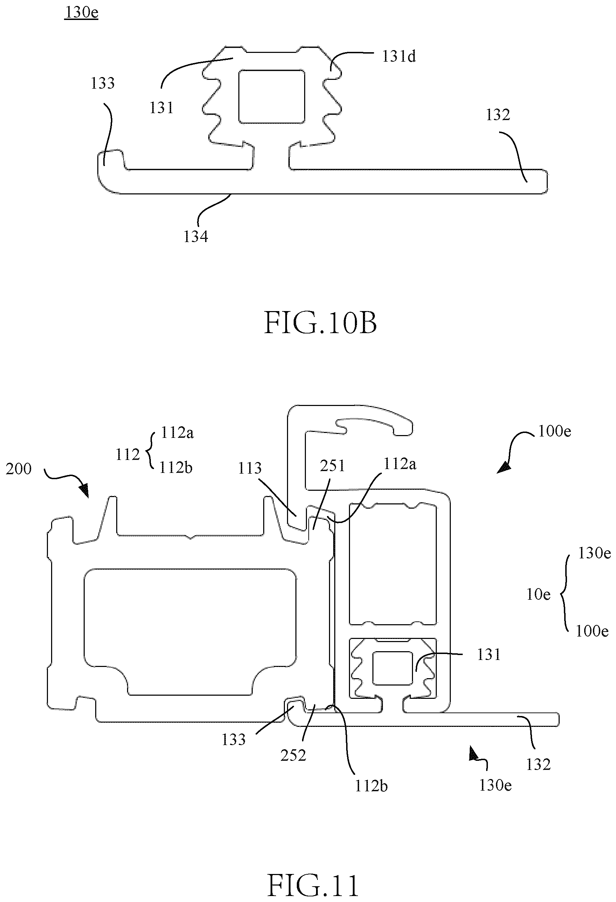

FIG. 10B is a schematic side view of a profile reinforcement for a photovoltaic module frame according to the fifth embodiment of the present application. Referring to FIG. 10B, the reinforcement 130e has a connecting portion 131, an extending portion 132 , and a second convex strip 133 protruding from an end of the extending portion 132. The extension portion 132 extends substantially along the horizontal direction to form the bottom of the reinforcement 130b. In this example, the connection portion 131 is substantially rectangular in cross-section, the shape and size of which are adapted to the sub-cavity 111b of the profile 100e. The outer edge of the connecting portion 131 has serrations 131d to improve the bonding strength with the profile 100e.

FIG. 11 is a schematic diagram of the cooperation between the profile component and the pressing piece according to the fifth embodiment of the present application. Referring to FIGS. 10A-11, the reinforcement 130e is combined with the profile 100e to form a profile component 10e. Specifically, the connecting portion 131 of the reinforcement 130e is inserted into the sub-cavity 111b through the opening 111c of the outer frame 110, and butts against the inner top surface of the mold cavity 111. At this time, a second bayonet 112b is formed between the second convex strip 133, the extending portion 132 and the lower end of the first side wall 110a. The first convex strip 113 and the second convex strip 133 face each other vertically, and the first bayonet 112a and the second bayonet 112b face each other, thereby forming a side groove 112 for installing the profile pressing piece. The structure of the profile pressing piece 200 is the same as that of the first embodiment. Referring to FIG. 11, when the profile pressing piece 200 is combined with the profile component 10b, the first protrusion 251 passes over the first convex strip 113 and snaps into the first bayonet 112a of the side groove 112, and the second protrusion 252 passes over the second convex strip 133 and snaps into the second bayonet 112b of the side groove 112.

In order to facilitate the installation of the profile pressing piece 200, the partial angle and size design of the profile component 10e in this embodiment can be referred to the design in the first embodiment, and will not be elaborated here.

Sixth embodiment

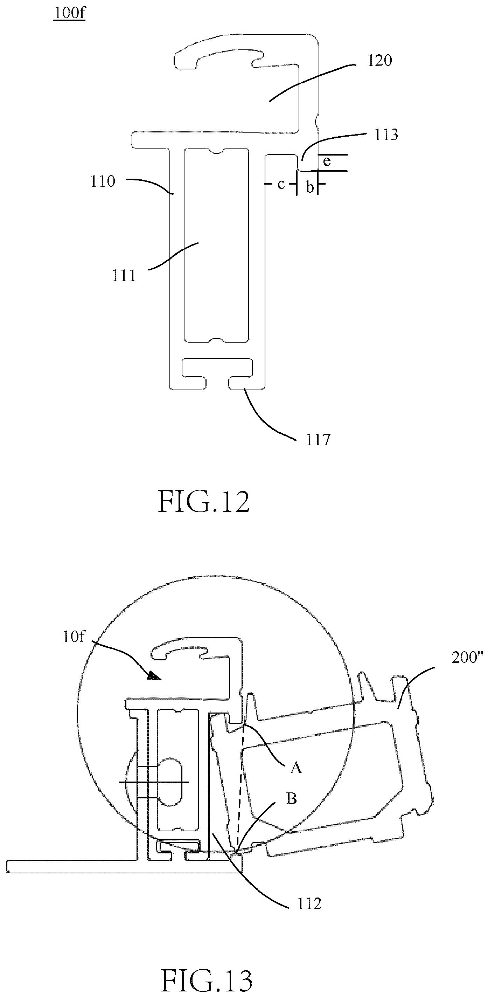

FIG. 12 is a schematic side view of a profile used for a photovoltaic module frame according to the sixth embodiment of the present application. Referring to FIG. 12, in this embodiment, the end surface of the first convex strip 113 of the profile 100f is horizontal, that is, the aforementioned $\alpha=0$. Correspondingly, the top surface of the first bayonet 112a is horizontal, that is, $\gamma=0$.

FIG. 13 is a schematic diagram of the cooperation between the profile component and the pressing piece according to the sixth embodiment of the present application. Referring to FIG. 12 and FIG. 13, the profile 100f and the reinforcement form a profile component 10f and are then assembled with the profile pressing piece 200''. The profile pressing piece 200'' first snaps into the first convex strip 113 of the profile 100f with the first groove 261 (referring to FIG. 2D), meanwhile the external endpoint A of the first groove 261 contacts the end surface of the first convex strip 113, the end surface of the second protrusion 252 bypasses the end surface of the second convex strip 133 and enters the side groove 112.

Under this design, the design of size parameters is simpler. When the profile component 10f and the profile pressing piece 200'' are matched, the space for accommodating a certain part should be slightly larger than that part. For example, as shown in FIG. 12 and FIG. 2D, the depth c of the side groove 112 is slightly larger than the thickness C of the first protrusion 251 (left-right direction in the figure), and the thickness of the projection of the first groove 261 in the horizontal direction is larger than the thickness $b$ of the first protrusion 113, the depth $c$ of the side groove 112 is also slightly larger than the thickness of the second protrusion 252 (left and right directions in the figure), and the thickness of the projection of the second groove 262 in the horizontal direction is slightly larger than the thickness of the second protrusion 114, the height $E$ of the first protrusion 251 is slightly larger than the height e of the first convex strip 113, and so on. The vertical distance between the end surface of the second protrusion 252 on the left and the bottom surface 255 of the profile pressing piece 200'' is $F$, then $F$ is less than or equal to the vertical distance $t$ between the bottom surface of the side groove 112 and the bottom surface of the reinforcement 134 (referring to FIG. 1B). In this way, after the profile component 10f and the profile pressing piece 200'' are assembled, the second protrusion 252 can be pressed against the bottom surface of the side groove 112.

In addition, the distance $L$ between the external endpoint A of the first groove 261 and the lower end B of the second protrusion 252 is less than or equal to the width $H$ of the side groove's notch, so that the profile pressing piece 200'' can be stuck into the side groove.

Other details in this embodiment that are similar to the previous implementation will not be described again.

FIG. 14A- FIG. 14C are schematic diagrams of the assembly steps of a profile component and a profile pressing piece according to an embodiment of the present application. As shown with reference to FIGS. 14A-14C, the method for installing a profile a pressing piece 200a and a profile 100a as described in the above embodiment is:

(1) Install a first coupling portion of a first profile pressing piece in a side groove of a profile with a photovoltaic module. As shown in FIG. 14A, four profile components 10a (two are shown in the figure) are installed around a photovoltaic module 300. First install a first profile pressing piece 200a1 in a side groove of one side of the profile component 10a (the right side shown in FIG. 14A), rotate the first profile pressing piece 200a1 at a smaller angle (such as 10-20° or 15-18°) to snap into the side groove 112; then rotate the first profile pressing piece 200a1 until the bottom surface of the first profile pressing piece 200a1 is parallel to the bottom surface of the profile. (2) Snap the side groove of the profile with the first profile pressing piece into a second coupling portion of a second profile pressing piece installed on a bracket by a fastener. As shown in FIG. 14B, a second profile pressing piece 200a2 is fixed on a bracket 400 through a fastener 211. It should be noted that the fastener 211 can be tightened at this time. Align a first convex strip 113 of the side groove 112 of the profile component 10a on the other side of the photovoltaic module 300 (the left side shown in FIG. 14B) with the first groove 261 of the second profile pressing piece 200a2 that has been fixed on the bracket 400, rotate the profile component about 10-20° or 15-18°, so that the second convex strip 133 of the side groove 112 of the left profile component 10a in the figure snaps into the second groove 262 of the second profile pressing piece 200a2. Afterwards, rotate the profile component until the bottom surface of the profile component is parallel to the second profile pressing piece.

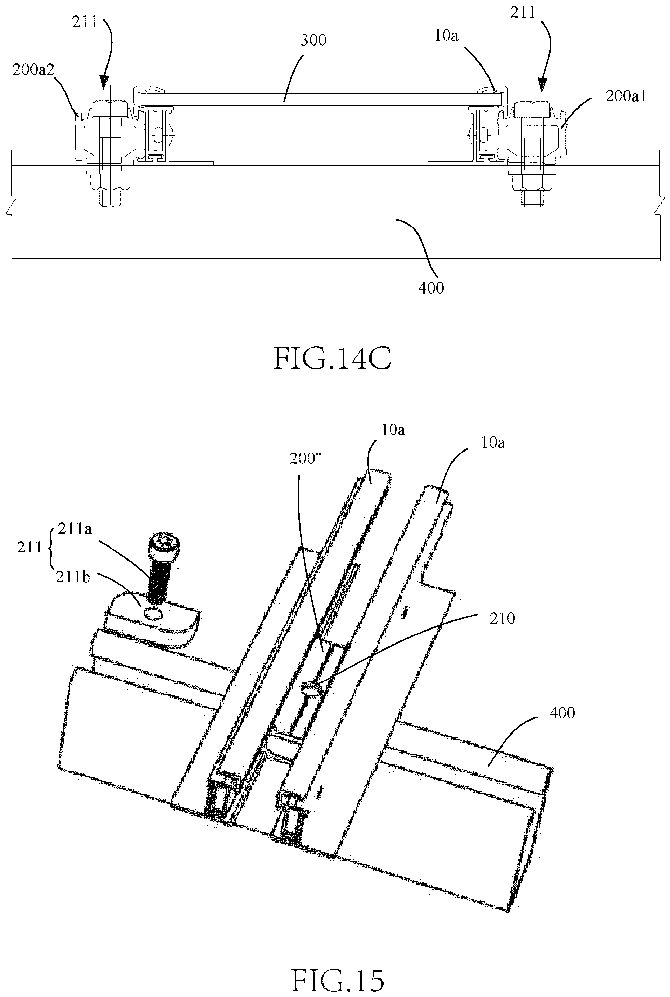

(3) Install the first profile pressing piece on the bracket through a fastener. As shown in FIG. 14C, fix the first profile pressing piece 200a1 installed in step (1) on the bracket 400 through another fastener 211.

When each profile pressing piece is combined with the profile, the gap between the side of the profile pressing piece (more specifically, the first side 241) and the side of the side groove 112 of the profile is less than or equal to 2 mm.

Repeat the above steps (1)-(3) to complete the installation of multiple profile components 10a and photovoltaic components 300.

FIG. 15 is a schematic assembly diagram of a profile component and a profile pressing piece according to an embodiment of the present application. With reference to the above content and what is shown in FIG. 15, the assembly method of the profile component 10a and the profile pressing piece 200'' in this embodiment is specifically as follows. Two profile components 10a are symmetrically fixed on both sides of the profile pressing piece 200'', and the left and right sides are connected by fixing the first protrusion 251 and the second protrusion 252 into the side groove 112. After the fixation is completed, the first groove 261 composed of the first protrusion 251 and the third protrusion 253 of the profile pressing piece 200'' (referring to FIG. 2D) fits the first convex strip 113 of the profile component 10a, and the second groove 262 composed of the second protrusion 252 and the fourth protrusion 254 of the profile pressing piece 200'' fits the second convex strip 114 of the profile pressing piece 10a. Further, the fastener 211 fix the profile pressing piece 200'' to the bracket 400 through the fastening hole 210, thereby simultaneously fixing the two profile components 10a installed on the left and right sides of the profile pressing piece 200''. Specifically, the fastener 211 includes a screw 211a and a nut 211b in this embodiment.

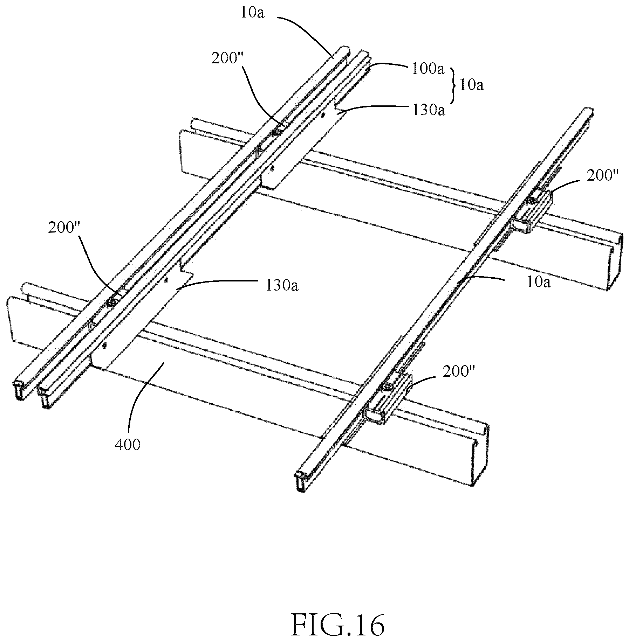

FIG. 16 is a schematic perspective view of photovoltaic module installation according to an embodiment of the present application. After going through the steps shown in FIGS. 14A-14C, part of the frame of the photovoltaic module that has been installed (with the photovoltaic cells and horizontal profiles hidden) is as shown in FIG. 16. The photovoltaic module frame includes a plurality of profile pressing pieces 200'' as described above and a plurality of strip-shaped profile components 10a. Each profile component 10a has a load-bearing part 120 for carrying the workpiece to be installed (as shown in Figure 1C), each profile component 10a has a side groove 112 on its side, and at least one profile pressing piece 200'' is installed on the side groove 112.

The plurality of profile components 10a substantially surround a closed area for carrying a photovoltaic component.

Optionally, at least some of the profile components 10a among the plurality of profile components 10a (the two profile components 10a on the left in the figure) are arranged adjacently, and the adjacently arranged profiles 10a share profile pressing pieces 200''.

In an embodiment of the present application, the length of the profile pressing piece 200'' is smaller than the length of the profile component 10a to save material.

In an embodiment of the present application, the profile pressing piece 200'' is not part of the photovoltaic module, but forms the support structure of the photovoltaic module together with the bracket 400. The profile component 10a on the frame of the photovoltaic module has a side groove, the photovoltaic module and the support structure are installed through the connection between the profile's side groove and the profile pressing piece, therefore the connection between the photovoltaic module and the support structure is in the form of a slot.

It should be noted that in the embodiment shown in FIG. 16, there are four profile pressing pieces 200'', which fix three profile components 10a, but the number of profile components 10a that can be installed during actual operation is not limited to this, and there is no limit to this number in this application.

Meanwhile, the present application uses specific words to describe the embodiments of the present application. For example, "one embodiment", "an embodiment", and/or "some embodiments" refer to a certain feature, structure or characteristic related to at least one embodiment of the present application. Therefore, it should be emphasized and noted that two or more references to "one embodiment" or "an embodiment" or "an alternative embodiment" in different places in this specification do not necessarily refer to the same embodiment. In addition, certain features, structures or characteristics of one or more embodiments of the present application may be properly combined.

In the same way, it should be noted that in order to simplify the expression disclosed in the present application and help the understanding of one or more embodiments of the application, in the foregoing description of the embodiments of the present application, sometimes multiple features are combined into one embodiment, drawings or descriptions thereof. However, this method of disclosure does not imply that the subject matter of the application requires more features than are recited in the claims. Indeed, embodiment features are less than all features of a single foregoing disclosed embodiment.

In some embodiments, numbers describing the quantity of components and attributes are used, it should be understood that such numbers used in the description of the embodiments use the modifiers "about", "approximately" or "substantially" in some examples. Unless otherwise stated, "about", "approximately" or "substantially" indicates that the stated figure allows for a variation of ±20%. Accordingly, in some embodiments, the numerical parameters used in the specification and claims are approximations that can vary depending upon the desired characteristics of individual embodiments. In some embodiments, numerical parameters should take into account the specified significant digits and adopt the general digit reservation method. Although the numerical ranges and parameters used in some embodiments of the present application to confirm the breadth of the scope are approximate values, in specific embodiments, such numerical values are set as precisely as practicable.

**Claims**

1. A profile component, **characterized by** including a profile (100a) and a reinforcement (130a),

> wherein the profile (100a) includes an outer frame (110) with a mold cavity (111) inside and a load-bearing part (120) located on the outer frame (110) and used to carry workpieces to be installed, wherein a first side wall (110a) and a first convex strip (113) spaced opposite to an upper end of the first side wall (110a), a first bayonet (112a) being formed between the first convex strip (113) and the upper end of the first side wall (110a), and
> wherein the reinforcement (130a) has a connecting portion (131), an extending portion (132) and a second convex strip (133) protruding from an end of the extending portion (132), and when the reinforcement (130a) is combined with the outer frame (110) through the connecting portion (131), a second bayonet (112b) is formed between the second convex strip (133), the extending portion (132) and a lower end of the first side wall (110a), wherein the first convex strip (113) is opposite to the second convex strip (133), and the first bayonet (112a) is opposite to the second bayonet (112b), forming a side groove (112) for installing a profile pressing piece.

2. The profile component according to claim 1, wherein the lower end of the side wall does not exceed an inner edge of the convex strip in an outward direction perpendicular to the first side wall (110a).

3. The profile component according to claim 1, wherein the connecting portion (131) includes an upwardly extending side plate (131a) adapted to be combined with a second side wall (110b) of the outer frame (110) through a fastener (135), the second side wall (110b) being opposite to the first side wall (110a).

4. The profile component according to claim 1 or 3, wherein the outer frame (110) has an opening (111c) in a bottom of the outer frame (110), and the connecting portion (131) includes a sub-connecting portion (131b) inserted into the mold cavity (111) through the opening (111c).

5. The profile component according to claim 1 or 3, wherein the connection portion (131) includes a bottom plate (131b) adapted to be combined with a bottom surface (114) of the outer frame (110) through a fastener (135).

6. The profile component according to claim 4, wherein the mold cavity (111) includes a plurality of sub-cavities, and the sub-connecting portion (131b) is inserted into one of the sub-cavities.

7. The profile component according to claim 4, wherein the mold cavity (111) is a single mold cavity, and the sub-connecting portion (131b) is close to or against an inner top surface of the mold cavity (111).

8. The profile component according to claim 1, wherein a top surface of the first bayonet (112a) and an end surface of the first convex strip (113) are inclined upward in the direction from inside to outside, assuming that a thickness of the first convex strip (113) is $b$, a height of the first convex strip (113) is $e$, a width of the first bayonet (112a) is c, a distance between the end surface of the first convex strip (113) and an end surface of the second convex strip (133) is H, an inclination angle of the end surface of the first convex strip (113) relative to a bottom surface of the profile (100a) is $\alpha$, and an inclination angle of a top surface of the first bayonet (112a) relative to the bottom surface of the profile (100a) is $\gamma$, then:

$$\alpha = arg tan\left(\frac{b+c}{H+e}\right)$$

$$\gamma \geq \alpha.$$

9. The profile component according to claim 8, wherein the inclination angles $\alpha$ and $\gamma$ are between 10-20°.

10. The profile component according to claim 1, wherein an inclination angle of a top surface of the first bayonet (112a) and an end surface of the first convex strip (113) relative to a bottom surface of the profile (100a) is 0°.

11. The profile component according to claim 1, wherein an end surface of the second convex strip (133) is inclined downward in a direction from inside to outside relative to a bottom surface (134) of the reinforcement (130a).

12. The profile component according to claim 11, wherein an inclination angle of the end surface of the second convex strip (133) relative to the bottom surface (134) of the reinforcement (130a) is between 10-20°.

13. The profile component according to claim 1, 8 or 10, wherein the profile pressing piece (200) has a coupling portion that is coupled to the side groove (112), the coupling portion including a first side and a second side and a third side that are respectively connected to both ends of the first side, wherein the connection between the first side and the second side has a first protrusion, and the connection between the first side and the third side has a second protrusion, and wherein when the profile (100a) is combined with the profile pressing piece (200), the first protrusion snaps into the first bayonet (112a), and the second protrusion snaps into the second bayonet (112b).

14. The profile component according to claim 13, wherein a vertical distance between a bottom surface of the second bayonet (112b) and a bottom surface of the reinforcement (130a) is greater than or equal to a vertical distance between an end surface of the second protrusion and the bottom surface (255) of the profile pressing piece (200).

15. The profile component according to claim 13, wherein the second side of the profile pressing piece (200) has a third protrusion spaced opposite to the first protrusion, and a first groove (261) is formed between the first protrusion and the third protrusion to cooperate with the first convex strip (113), and wherein a bottom surface of the first groove (261) is inclined upward in a direction from outside to inside, and an inclination angle of the first groove (261) relative to a bottom surface of the profile pressing piece (200) is greater than or equal to an inclination angle of an end surface of the first convex strip (113) relative to a bottom surface (114) of the profile (100a).

16. The profile component according to claim 15, wherein an outer surface of the third protrusion is inclined inward in a direction from bottom to top, and an inclination angle of the outer surface relative to the first side is greater than or equal to an inclination angle of an end surface of the first convex strip (113) relative to the bottom surface (114) of the profile (100a).

17. The profile component according to claim 1, wherein a height of the first convex strip (113) is 2.5-3.5mm, and/or a height of the second convex strip (133) is 0.8-1.5mm.

18. The profile component according to claim 1, wherein when the profile (100a) is combined with the profile pressing piece (200), a gap between the first side wall (110a) and a first side of the profile pressing piece (200) is less than or equal to 2 mm.

19. The profile component according to claim 18, wherein the first side wall (110a) has a lateral protrusion.

20. A profile including an outer frame (110) with a mold cavity (111) inside and a load-bearing part (120) located above the outer frame (110) and used to load a workpiece to be installed, wherein the outer frame (110) further includes a side wall (110a) and a convex strip (113) spaced opposite to an upper end of the side wall, a bayonet (112a) being formed between the convex strip and the upper end of the side wall, and a lower end of the side wall (110a) does not exceed an inner edge of the convex strip (113) in an outward direction perpendicular to the side wall.

21. The profile according to claim 20, wherein the lower end of the side wall and the upper end of the side wall are flush with each other in an extending direction of the side wall.

22. The profile according to claim 20, wherein the outer frame (110) has an opening (111c) in a bottom of the outer frame (110).

23. The profile according to claim 20, wherein an inclination angle $\alpha$ of an end surface of the convex strip relative to a bottom surface of the profile (100a) and an inclination angle $\gamma$ of a top surface of the bayonet relative to a bottom surface of the profile (100a) are between 10-20°.

24. The profile according to claim 20, wherein an inclination angle of a top surface of the bayonet and an end surface of the convex strip relative to a bottom surface of the profile (100a) is 0°.

25. The profile according to claim 20, wherein a height of the convex strips is 2.5-3.5mm.

26. A profile reinforcement suitable for combination with a profile, wherein the profile (100a) includes an outer frame (110) having a cavity inside the outer frame (110), a first side wall (110a) and a first convex strip (113) spaced opposite to an upper end of the first side wall (110a), a first bayonet (112a) being formed between the first convex strip (113) and an upper end of the first side wall (110a), wherein

the profile reinforcement has a connecting portion (131), an extension portion (132) and a second convex strip (133) protruding from an end of the extension portion (132), and when the reinforcement (130a) is combined with the outer frame (110) through the connecting portion (131), a second bayonet (112b) is formed between the second convex strip (133), the extending portion (132) and an lower end of the first side wall (110a), and wherein the first convex strip (113) is opposite to the second convex strip (133), and the first bayonet (112a) is opposite to the second bayonet (112b), forming a side groove (112) for installing a profile pressing piece (200).

27. The profile reinforcement according to claim 26, wherein the connection portion includes an upwardly extending side plate (131a) adapted to be combined with a second side wall (110b) of the outer frame (110) through a fastener (135), the second side wall (110b) being opposite to the first side wall (110a).

28. The profile reinforcement according to claim 26 or 27, wherein the outer frame (110) has an opening (111c) in a bottom of the outer frame (110), and the connecting portion (131) includes a sub-connecting portion (131b) inserted into the mold cavity (111) through the opening (111c).

29. The profile reinforcement according to claim 26 or 27, wherein the connection portion includes a bottom plate (131b) adapted to be combined with the bottom surface of the outer frame (110) through a fastener (135).

30. The profile reinforcement according to claim 26, wherein an end surface of the second convex strip (133) is inclined downward in a direction from inside to outside relative to a bottom surface of the reinforcement (130a).

31. A profile reinforcement of claim 30, wherein an inclination angle of the end surface of the second convex strip (133) relative to the bottom surface of the reinforcement (130a) is between 10-20°.

32. A photovoltaic module frame, including:
a plurality of profile components according to any of claims 1-19, wherein at least one profile pressing piece is installed on the side groove (112) of the profile component.

33. The photovoltaic module frame according to claim 32, wherein multiple profile components surround a closed area for carrying a photovoltaic component.

34. The photovoltaic module frame according to claim 32, wherein at least some of the plurality of profile components are arranged adjacently, and the adjacently arranged profile components share the profile pressing piece (200).

35. A photovoltaic system including:

a photovoltaic module frame according to any of claims 32-34;
a plurality of photovoltaic cells arranged in the photovoltaic module frame.

**Patentansprüche**

1. Profilbauteil, **gekennzeichnet durch** ein Profil (100a) und eine Verstärkung (130a),
wobei das Profil (100a) einen Außenrahmen (110) mit einem Formhohlraum (111) im Inneren und einen lasttragenden Teil (120) umfasst, der auf dem Außenrahmen (110) angeordnet und zur Aufnahme von zu installierenden Werkstücken verwendet wird, wobei eine erste Seitenwand (110a) und ein erster konvexer Streifen (113) beabstandet gegenüber einem oberen Ende der ersten Seitenwand (110a) angeordnet sind, wobei ein erstes Bajonett (112a) zwischen dem ersten konvexen Streifen (113) und dem oberen Ende der ersten Seitenwand (110a) gebildet wird, und wobei die Verstärkung (130a) einen Verbindungsabschnitt (131), einen Verlängerungsabschnitt (132) und einen zweiten konvexen Streifen (133) aufweist, der von einem Ende des Verlängerungsabschnitts (132) vorsteht, und wenn die Verstärkung (130a) mit dem Außenrahmen (110) durch den Verbindungsabschnitt (131) verbunden wird, ein zweites Bajonett (112b) zwischen dem zweiten konvexen Streifen (133), dem Verlängerungsabschnitt (132) und einem unteren Ende der ersten Seitenwand (110a) gebildet wird, wobei der erste konvexe Streifen (113) dem zweiten konvexen Streifen (133) gegenüberliegt und das erste Bajonett (112a) dem zweiten Bajonett (112b) gegenüberliegt, wodurch eine Seitennut (112) zur Installation eines Profilpressstücks gebildet wird.

2. Profilbauteil nach Anspruch 1, wobei das untere Ende der Seitenwand ein inneres Ende des konvexen Streifens in einer nach außen gerichteten Richtung senkrecht zur ersten Seitenwand (110a) nicht überschreitet.

3. Profilbauteil nach Anspruch 1, wobei der Verbindungsabschnitt (131) eine nach oben verlaufende Seitenplatte (131a) umfasst, die dazu geeignet ist, mit einer zweiten Seitenwand (110b) des Außenrahmens (110) durch ein Befestigungselement (135) verbunden zu werden, wobei die zweite Seitenwand (110b) der ersten Seitenwand (110a) gegenüberliegt.

4. Profilbauteil nach Anspruch 1 oder 3, wobei der Außenrahmen (110) eine Öffnung (111c) in einem Boden des Außenrahmens (110) aufweist, und der Verbindungsabschnitt (131) einen Unter-Verbindungsabschnitt (131b) umfasst, der durch die Öffnung (111c) in den Formhohlraum (111) eingeführt wird.

5. Profilbauteil nach Anspruch 1 oder 3, wobei der Verbindungsabschnitt (131) eine Bodenplatte (131b) umfasst, die dazu geeignet ist, mit einer Bodenfläche (114) des Außenrahmens (110) durch ein Befestigungselement (135) verbunden zu werden.

6. Profilbauteil nach Anspruch 4, wobei der Formhohlraum (111) eine Vielzahl von Unter-Hohlräumen umfasst, und der Unter-Verbindungsabschnitt (131b) in einen der Unter-Hohlräume eingeführt wird.

7. Profilbauteil nach Anspruch 4, wobei der Formhohlraum (111) ein einzelner Formhohlraum ist, und der Unter-Verbindungsabschnitt (131b) nahe an oder gegen eine innere Oberfläche des Formhohlraums (111) angeordnet ist.

8. Profilbauteil nach Anspruch 1, wobei eine Oberfläche des ersten Bajonetts (112a) und eine Endfläche des ersten konvexen Streifens (113) in der Richtung von innen nach außen nach oben geneigt sind, wobei angenommen wird, dass eine Dicke des ersten konvexen Streifens (113) b ist, eine Höhe des ersten konvexen Streifens (113) e ist, eine Breite des ersten Bajonetts (112a) c ist, ein Abstand zwischen der Endfläche des ersten konvexen Streifens (113) und einer Endfläche des zweiten konvexen Streifens (133) H ist, ein Neigungswinkel der Endfläche des ersten konvexen Streifens (113) relativ zu einer Bodenfläche des Profils (100a) α ist, und ein Neigungswinkel einer Oberfläche des ersten Bajonetts (112a) relativ zur Bodenfläche des Profils (100a) γ ist, dann:

$$\alpha = argtan\left(\frac{b + c}{H + e}\right)$$

γ≥α.

9. Profilbauteil nach Anspruch 8, wobei die Neigungswinkel α und γ zwischen 10-20° liegen.

10. Profilbauteil nach Anspruch 1, wobei ein Neigungswinkel einer Oberfläche des ersten Bajonetts (112a) und einer Endfläche des ersten konvexen Streifens (113) relativ zu einer Bodenfläche des Profils (100a) 0° beträgt.

11. Profilbauteil nach Anspruch 1, wobei eine Endfläche des zweiten konvexen Streifens (133) in einer Richtung von innen nach außen relativ zu einer Bodenfläche (134) der Verstärkung (130a) nach unten geneigt ist.

12. Profilbauteil nach Anspruch 11, wobei ein Neigungswinkel der Endfläche des zweiten konvexen Streifens (133) relativ zur Bodenfläche (134) der Verstärkung (130a) zwischen 10-20° liegt.

13. Profilbauteil nach Anspruch 1, 8 oder 10, wobei das Profilpressstück (200) einen Kopplungsabschnitt aufweist, der mit der Seitennut (112) gekoppelt ist, wobei der Kopplungsabschnitt eine erste Seite und eine zweite Seite und eine dritte Seite umfasst, die jeweils mit beiden Enden der ersten Seite verbunden sind, wobei die Verbindung zwischen der ersten Seite und der zweiten Seite einen ersten Vorsprung aufweist, und die Verbindung zwischen der ersten Seite und der dritten Seite einen zweiten Vorsprung aufweist, und wobei, wenn das Profil (100a) mit dem Profilpressstück (200) verbunden wird, der erste Vorsprung in das erste Bajonett (112a) einrastet und der zweite Vorsprung in das zweite Bajonett (112b) einrastet.

14. Profilbauteil nach Anspruch 13, wobei ein vertikaler Abstand zwischen einer Bodenfläche des zweiten Bajonetts (112b) und einer Bodenfläche der Verstärkung (130a) größer oder gleich einem vertikalen Abstand zwischen einer Endfläche des zweiten Vorsprungs und der Bodenfläche (255) des Profilpressstücks (200) ist.

15. Profilbauteil nach Anspruch 13, wobei die zweite Seite des Profilpressstücks (200) einen dritten Vorsprung aufweist, der beabstandet gegenüber dem ersten Vorsprung angeordnet ist, und eine erste Nut (261) zwischen dem ersten Vorsprung und dem dritten Vorsprung gebildet wird, um mit dem ersten konvexen Streifen (113) zusammenzuwirken, und wobei eine Bodenfläche der ersten Nut (261) in einer Richtung von außen nach innen nach oben geneigt ist, und ein Neigungswinkel der ersten Nut (261) relativ zu einer Bodenfläche des Profilpressstücks (200) größer oder gleich einem Neigungswinkel einer Endfläche des ersten konvexen Streifens (113) relativ zu einer Bodenfläche (114) des Profils (100a) ist.

16. Profilbauteil nach Anspruch 15, wobei eine äußere Oberfläche des dritten Vorsprungs in einer Richtung von unten nach oben nach innen geneigt ist, und ein Neigungswinkel der äußeren Oberfläche relativ zur ersten Seite größer oder gleich einem Neigungswinkel einer Endfläche des ersten konvexen Streifens (113) relativ zur Bodenfläche (114) des Profils (100a) ist.

17. Profilbauteil nach Anspruch 1, wobei eine Höhe des ersten konvexen Streifens (113) 2,5-3,5 mm beträgt, und/oder eine Höhe des zweiten konvexen Streifens (133) 0,8-1,5 mm beträgt.

18. Profilbauteil nach Anspruch 1, wobei, wenn das Profil (100a) mit dem Profilpressstück (200) verbunden wird, ein Spalt zwischen der ersten Seitenwand (110a) und einer ersten Seite des Profilpressstücks (200) kleiner oder gleich 2 mm ist.

19. Profilbauteil nach Anspruch 18, wobei die erste Seitenwand (110a) einen seitlichen Vorsprung aufweist.

20. Profil, das einen Außenrahmen (110) mit einem Formhohlraum (111) im Inneren und einen lasttragenden Teil (120) umfasst, der oberhalb des Außenrahmens (110) angeordnet und zur Aufnahme eines zu installierenden Werkstücks verwendet wird, wobei der Außenrahmen (110) ferner eine Seitenwand (110a) und einen konvexen Streifen (113) umfasst, der beabstandet gegenüber einem oberen Ende der Seitenwand angeordnet ist, wobei ein Bajonett (112a) zwischen dem konvexen Streifen und dem oberen Ende der Seitenwand gebildet wird, und ein unteres Ende der Seitenwand (110a) eine innere Kante des konvexen Streifens (113) in einer nach außen gerichteten Richtung senkrecht zur Seitenwand nicht überschreitet.

21. Profil nach Anspruch 20, wobei das untere Ende der Seitenwand und das obere Ende der Seitenwand in einer Verlängerungsrichtung der Seitenwand bündig miteinander sind.

22. Profil nach Anspruch 20, wobei der Außenrahmen (110) eine Öffnung (111c) in einem Boden des Außenrahmens (110) aufweist.

23. Profil nach Anspruch 20, wobei ein Neigungswinkel α einer Endfläche des konvexen Streifens relativ zu einer Bodenfläche des Profils (100a) und ein Neigungswinkel γ einer Oberfläche des Bajonetts relativ zu einer Bodenfläche des Profils (100a) zwischen 10-20° liegen.

24. Profil nach Anspruch 20, wobei ein Neigungswinkel einer Oberfläche des Bajonetts und einer Endfläche des konvexen Streifens relativ zu einer Bodenfläche des Profils (100a) 0° beträgt.

25. Profil nach Anspruch 20, wobei eine Höhe der konvexen Streifen 2,5-3,5 mm beträgt.

26. Profilverstärkung, die zur Verbindung mit einem Profil geeignet ist, wobei das Profil (100a) einen Außenrahmen (110) mit einem Hohlraum im Inneren des Außenrahmens (110), eine erste Seitenwand (110a) und einen ersten konvexen Streifen (113) umfasst, der beabstandet gegenüber einem oberen Ende der ersten Seitenwand (110a) angeordnet ist, wobei ein erstes Bajonett (112a) zwischen dem ersten konvexen Streifen (113) und einem oberen Ende der ersten Seitenwand (110a) gebildet wird, wobei die Profilverstärkung einen Verbindungsabschnitt (131), einen Verlängerungsabschnitt (132) und einen zweiten konvexen Streifen (133) aufweist, der von einem Ende des Verlängerungsabschnitts (132) vorsteht, und wenn die Verstärkung (130a) mit dem Außenrahmen (110) durch den Verbindungsabschnitt (131) verbunden wird, ein zweites Bajonett (112b) zwischen dem zweiten konvexen Streifen (133), dem Verlängerungsabschnitt (132) und einem unteren Ende der ersten Seitenwand (110a) gebildet wird, und wobei der erste konvexe Streifen (113) dem zweiten konvexen Streifen (133) gegenüberliegt und das erste Bajonett (112a) dem zweiten Bajonett (112b) gegenüberliegt, wodurch eine Seitennut (112) zur Installation eines Profilpressstücks (200) gebildet wird.

27. Profilverstärkung nach Anspruch 26, wobei der Verbindungsabschnitt eine nach oben verlaufende Seitenplatte (131a) umfasst, die dazu geeignet ist, mit einer zweiten Seitenwand (110b) des Außenrahmens (110) durch ein Befestigungselement (135) verbunden zu werden, wobei die zweite Seitenwand (110b) der ersten Seitenwand (110a) gegenüberliegt.

28. Profilverstärkung nach Anspruch 26 oder 27, wobei der Außenrahmen (110) eine Öffnung (111c) in einem Boden des Außenrahmens (110) aufweist, und der Verbindungsabschnitt (131) einen Unter-Verbindungsabschnitt (131b) umfasst, der durch die Öffnung (111c) in den Formhohlraum (111) eingeführt wird.

29. Profilverstärkung nach Anspruch 26 oder 27, wobei der Verbindungsabschnitt eine Bodenplatte (131b) umfasst, die dazu geeignet ist, mit der Bodenfläche des Außenrahmens (110) durch ein Befestigungselement (135) verbunden zu werden.

30. Profilverstärkung nach Anspruch 26, wobei eine Endfläche des zweiten konvexen Streifens (133) in einer Richtung von innen nach außen relativ zu einer Bodenfläche der Verstärkung (130a) nach unten geneigt ist.

31. Profilverstärkung nach Anspruch 30, wobei ein Neigungswinkel der Endfläche des zweiten konvexen Streifens (133) relativ zur Bodenfläche der Verstärkung (130a) zwischen 10-20° liegt.

**32.** Photovoltaikmodulrahmen, umfassend:
eine Vielzahl von Profilbauteilen nach einem der Ansprüche 1 bis 19, wobei mindestens ein Profilpressstück auf der Seitennut (112) des Profilbauteils installiert ist.

**33.** Photovoltaikmodulrahmen nach Anspruch 32, wobei mehrere Profilbauteile einen geschlossenen Bereich zur Aufnahme eines Photovoltaikbauteils umgeben.

**34.** Photovoltaikmodulrahmen nach Anspruch 32, wobei mindestens einige der Vielzahl von Profilbauteilen benachbart angeordnet sind, und die benachbart angeordneten Profilbauteile das Profilpressstück (200) gemeinsam nutzen.

**35.** Photovoltaiksystem, umfassend:

einen Photovoltaikmodulrahmen nach einem der Ansprüche 32 bis 34;
eine Vielzahl von Photovoltaikzellen, die in dem Photovoltaikmodulrahmen angeordnet sind.

## Revendications

**1.** Composant de profilé, **caractérisé en ce qu'**il comprend un profilé (100a) et un renfort (130a), dans lequel le profilé (100a) comprend un cadre extérieur (110) avec une cavité de moulage (111) à l'intérieur et une partie porteuse (120) qui est située sur le cadre extérieur (110) et utilisée pour porter des pièces à usiner à installer, dans lequel une première paroi latérale (110a) et une première bande convexe (113) qui est espacée en face d'une extrémité supérieure de la première paroi latérale (110a), une première baïonnette (112a) étant formée entre la première bande convexe (113) et l'extrémité supérieure de la première paroi latérale (110a), et
dans lequel le renfort (130a) a une partie de connexion (131), une partie d'extension (132) et une seconde bande convexe (133) qui fait saillie à partir d'une extrémité de la partie d'extension (132), et lorsque le renfort (130a) est combiné avec le cadre extérieur (110) par l'intermédiaire de la partie de connexion (131), une seconde baïonnette (112b) est formée entre la seconde bande convexe (133), la partie d'extension (132) et une extrémité inférieure de la première paroi latérale (110a), dans lequel la première bande convexe (113) est en face de la seconde bande convexe (133), et la première baïonnette (112a) est en face de la seconde baïonnette (112b), formant une rainure latérale (112) pour installer une pièce de pressage de profilé.

**2.** Composant de profilé selon la revendication 1, dans lequel l'extrémité inférieure de la paroi latérale ne dépasse pas un bord intérieur de la bande convexe dans une direction vers l'extérieur perpendiculaire à la première paroi latérale (110a).

**3.** Composant de profilé selon la revendication 1, dans lequel la partie de connexion (131) comprend une plaque latérale (131a) qui s'étend vers le haut et qui est adaptée pour être combinée avec une seconde paroi latérale (110b) du cadre extérieur (110) par l'intermédiaire d'un élément de fixation (135), la seconde paroi latérale (110b) étant en face de la première paroi latérale (110a).

**4.** Composant de profilé selon la revendication 1 ou 3, dans lequel le cadre extérieur (110) a une ouverture (111c) dans un fond du cadre extérieur (110), et la partie de connexion (131) comprend une sous-partie de connexion (131b) qui est insérée dans la cavité de moulage (111) par l'intermédiaire de l'ouverture (111c).

**5.** Composant de profilé selon la revendication 1 ou 3, dans lequel la partie de connexion (131) comprend une plaque de fond (131b) qui est adaptée pour être combinée avec une surface inférieure (114) du cadre extérieur (110) par l'intermédiaire d'un élément de fixation (135).

**6.** Composant de profilé selon la revendication 4, dans lequel la cavité de moulage (111) comprend une pluralité de sous-cavités, et la sous-partie de connexion (131b) est insérée dans l'une des sous-cavités.

**7.** Composant de profilé selon la revendication 4, dans lequel la cavité de moulage (111) est une cavité de moulage unique, et la sous-partie de connexion (131b) est proche de ou contre une surface supérieure interne de la cavité de moulage (111).

**8.** Composant de profilé selon la revendication 1, dans lequel une surface supérieure de la première baïonnette (112a) et une surface d'extrémité de la première bande convexe (113) sont inclinées vers le haut dans la direction de l'intérieur vers l'extérieur, en supposant qu'une épaisseur de la première bande convexe (113) est b, une hauteur de la première bande convexe (113) est e, une largeur de la première baïonnette (112a) est c, une distance entre la surface d'extrémité de la première bande convexe (113) et une surface d'extrémité de la seconde bande convexe (133) est H, un angle d'inclinaison de la surface d'extrémité de la première bande convexe (113) par rapport à une surface inférieure du profilé (100a) est $\alpha$, et un angle d'inclinaison d'une surface supérieure de la première baïonnette (112a) par rapport à la surface inférieure du profilé (100a) est $\gamma$, alors :

$$\alpha = argtan\left(\frac{b+c}{H+e}\right)$$

$$\gamma \geq \alpha.$$

**9.** Composant de profilé selon la revendication 8, dans lequel les angles d'inclinaison $\alpha$ et $\gamma$ sont entre 10-20°.

**10.** Composant de profilé selon la revendication 1, dans lequel un angle d'inclinaison d'une surface supérieure de la première baïonnette (112a) et d'une surface d'extrémité de la première bande convexe (113) par rapport à une surface inférieure du profilé (100a) est de 0°.

**11.** Composant de profilé selon la revendication 1, dans lequel une surface d'extrémité de la seconde bande convexe (133) est inclinée vers le bas dans une direction de l'intérieur vers l'extérieur par rapport à une surface inférieure (134) du renfort (130a).

**12.** Composant de profilé selon la revendication 11, dans lequel un angle d'inclinaison de la surface d'extrémité de la seconde bande convexe (133) par rapport à la surface inférieure (134) du renfort (130a) est entre 10-20°.

**13.** Composant de profilé selon la revendication 1, 8 ou 10, dans lequel la pièce de pressage de profilé (200) a une partie d'accouplement qui est accouplée à la rainure latérale (112), la partie d'accouplement comprenant un premier côté et un second côté et un troisième côté qui sont respectivement connectés aux deux extrémités du premier côté, dans lequel la connexion entre le premier côté et le second côté a une première saillie, et la connexion entre le premier côté et le troisième côté a une seconde saillie, et dans lequel lorsque le profilé (100a) est combiné avec la pièce de pressage de profilé (200), la première saillie s'enclenche dans la première baïonnette (112a), et la seconde saillie s'enclenche dans la seconde baïonnette (112b).

**14.** Composant de profilé selon la revendication 13, dans lequel une distance verticale entre une surface inférieure de la seconde baïonnette (112b) et une surface inférieure du renfort (130a) est supérieure ou égale à une distance verticale entre une surface d'extrémité de la seconde saillie et la surface inférieure (255) de la pièce de pressage de profilé (200).

**15.** Composant de profilé selon la revendication 13, dans lequel le second côté de la pièce de pressage de profilé (200) a une troisième saillie qui est espacée en face de la première saillie, et une première rainure (261) est formée entre la première saillie et la troisième saillie pour coopérer avec la première bande convexe (113), et dans lequel une surface inférieure de la première rainure (261) est inclinée vers le haut dans une direction de l'extérieur vers l'intérieur, et un angle d'inclinaison de la première rainure (261) par rapport à une surface inférieure de la pièce de pressage de profilé (200) est supérieur ou égal à un angle d'inclinaison d'une surface d'extrémité de la première bande convexe (113) par rapport à une surface inférieure (114) du profilé (100a).

**16.** Composant de profilé selon la revendication 15, dans lequel une surface extérieure de la troisième saillie est inclinée vers l'intérieur dans une direction du bas vers le haut, et un angle d'inclinaison de la surface extérieure par rapport au premier côté est supérieur ou égal à un angle d'inclinaison d'une surface d'extrémité de la première bande convexe (113) par rapport à la surface inférieure (114) du profilé (100a).

**17.** Composant de profilé selon la revendication 1, dans lequel une hauteur de la première bande convexe (113) est de 2,5-3,5 mm, et/ou une hauteur de la seconde bande convexe (133) est de 0,8-1,5 mm.

**18.** Composant de profilé selon la revendication 1, dans lequel lorsque le profilé (100a) est combiné avec la pièce de pressage de profilé (200), un espace entre la première paroi latérale (110a) et un premier côté de la pièce de pressage de profilé (200) est inférieur ou égal à 2 mm.

**19.** Composant de profilé selon la revendication 18, dans lequel la première paroi latérale (110a) a une saillie latérale.

**20.** Profilé comprenant un cadre extérieur (110) avec une cavité de moulage (111) à l'intérieur et une partie porteuse (120) qui est située au-dessus du cadre extérieur (110) et utilisée pour charger une pièce à usiner à installer, dans lequel le cadre extérieur (110) comprend en outre une paroi latérale (110a) et une bande convexe (113) qui est espacée en face d'une extrémité supérieure de la paroi latérale, une baïonnette (112a) étant formée entre la bande convexe et l'extrémité supérieure de la paroi latérale, et une extrémité inférieure de la paroi latérale (110a) ne dépasse pas un bord intérieur de la bande convexe (113) dans une direction vers l'extérieur perpendiculaire à la paroi latérale.

**21.** Profilé selon la revendication 20, dans lequel l'extrémité inférieure de la paroi latérale et l'extrémité supérieure de la paroi latérale sont alignées l'une avec l'autre dans une direction d'extension de la paroi latérale.

**22.** Profilé selon la revendication 20, dans lequel le cadre extérieur (110) a une ouverture (111c) dans un fond du cadre extérieur (110).

**23.** Profilé selon la revendication 20, dans lequel un angle d'inclinaison α d'une surface d'extrémité de la bande convexe par rapport à une surface inférieure du profilé (100a) et un angle d'inclinaison γ d'une surface supérieure de la baïonnette par rapport à une surface inférieure du profilé (100a) sont entre 10-20°.

**24.** Profilé selon la revendication 20, dans lequel un angle d'inclinaison d'une surface supérieure de la baïonnette et d'une surface d'extrémité de la bande convexe par rapport à une surface inférieure du profilé (100a) est de 0°.

**25.** Profilé selon la revendication 20, dans lequel une hauteur des bandes convexes est de 2,5-3,5 mm.

**26.** Renfort de profilé approprié pour la combinaison avec un profilé, dans lequel le profilé (100a) comprend un cadre extérieur (110) ayant une cavité à l'intérieur du cadre extérieur (110), une première paroi latérale (110a) et une première bande convexe (113) qui est espacée en face d'une extrémité supérieure de la première paroi latérale (110a), une première baïonnette (112a) étant formée entre la première bande convexe (113) et une extrémité supérieure de la première paroi latérale (110a), dans lequel
le renfort de profilé a une partie de connexion (131), une partie d'extension (132) et une seconde bande convexe (133) qui fait saillie à partir d'une extrémité de la partie d'extension (132), et lorsque le renfort (130a) est combiné avec le cadre extérieur (110) par l'intermédiaire de la partie de connexion (131), une seconde baïonnette (112b) est formée entre la seconde bande convexe (133), la partie d'extension (132) et une extrémité inférieure de la première paroi latérale (110a), et dans lequel la première bande convexe (113) est en face de la seconde bande convexe (133), et la première baïonnette (112a) est en face de la seconde baïonnette (112b), formant une rainure latérale (112) pour installer une pièce de pressage de profilé (200).

**27.** Renfort de profilé selon la revendication 26, dans lequel la partie de connexion comprend une plaque latérale (131a) qui s'étend vers le haut et qui est adaptée pour être combinée avec une seconde paroi latérale (110b) du cadre extérieur (110) par l'intermédiaire d'un élément de fixation (135), la seconde paroi latérale (110b) étant en face de la première paroi latérale (110a).

**28.** Renfort de profilé selon la revendication 26 ou 27, dans lequel le cadre extérieur (110) a une ouverture (111c) dans un fond du cadre extérieur (110), et la partie de connexion (131) comprend une sous-partie de connexion (131b) qui est insérée dans la cavité de moulage (111) par l'intermédiaire de l'ouverture (111c).

**29.** Renfort de profilé selon la revendication 26 ou 27, dans lequel la partie de connexion comprend une plaque de fond (131b) qui est adaptée pour être combinée avec la surface inférieure du cadre extérieur (110) par l'intermédiaire d'un élément de fixation (135).

**30.** Renfort de profilé selon la revendication 26, dans lequel une surface d'extrémité de la seconde bande convexe (133) est inclinée vers le bas dans une direction de l'intérieur vers l'extérieur par rapport à une surface inférieure du renfort (130a).

**31.** Renfort de profilé selon la revendication 30, dans lequel un angle d'inclinaison de la surface d'extrémité de la seconde bande convexe (133) par rapport à la surface inférieure du renfort (130a) est entre 10-20°.

**32.** Cadre de module photovoltaïque, comprenant :
une pluralité de composants de profilé selon l'une quelconque des revendications 1 à 19, dans lequel au moins une pièce de pressage de profilé est installée sur la rainure latérale (112) du composant de profilé.

**33.** Cadre de module photovoltaïque selon la revendication 32, dans lequel de multiples composants de profilé entourent une zone fermée pour porter un composant photovoltaïque.

**34.** Cadre de module photovoltaïque selon la revendication 32, dans lequel au moins certains de la pluralité de composants de profilé sont disposés de manière adjacente, et les composants de profilé qui sont disposés de manière adjacente partagent la pièce de pressage de profilé (200).

**35.** Système photovoltaïque comprenant :

un cadre de module photovoltaïque selon l'une quelconque des revendications 32 à 34 ;
une pluralité de cellules photovoltaïques qui sont disposées dans le cadre de module photovoltaïque.

100a

FIG.1A

130a

FIG.1B

10a

FIG.1C

200

FIG.2A

FIG.2B

FIG.2C

FIG.2D

FIG.3

100b

120

113

112a

110a

110

111

110b

114    111c

FIG.4A

130

131

133    132

134

FIG.4B

FIG.5

FIG.6A

130c

135

131a
131
131b

133

135

132

134

## FIG.6B

112

112a
112b
200

113   251   112a

133

252   112b   131b   130c   132

100c   130c
10c
100c

131a

135

## FIG.7

100d

FIG.8A

130d

FIG.8B

FIG.9

FIG.10A

130e

FIG.10B

FIG.11

100f

120

113

e

110

c

b

111

117

FIG.12

10f

200"

A

B

112

FIG.13

FIG.14A

FIG.14B

FIG.14C

FIG.15

FIG.16

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2318780 B1